# EUROPEAN PATENT SPECIFICATION

(11) **EP 3 222 692 B1**
(45) Date of publication and mention of the grant of the patent: **12.07.2023**
(21) Application number: 15860929.7
(22) Date of filing: 18.09.2015
(51) Int. Cl.: C09J 201/00, C09J 4/02, C09J 5/06, C09J 11/06, H01L 21/52, H01L 25/065, H01L 25/07, H01L 25/18

(54) **INKJET PHOTO- AND HEAT-CURABLE ADHESIVE, SEMICONDUCTOR DEVICE MANUFACTURING METHOD, AND ELECTRONIC PART**
LICHT- UND WÄRMEHÄRTENDER TINTENSTRAHLKLEBSTOFF, HALBLEITERBAUELEMENTHERSTELLUNGSVERFAHREN UND ELEKTRONISCHES TEIL
ADHÉSIF PHOTO- ET THERMO-DURCISSABLE POUR JET D'ENCRE, PROCÉDÉ DE FABRICATION DE DISPOSITIF À SEMI-CONDUCTEUR ET PIÈCE ÉLECTRONIQUE

(30) Priority: 17.11.2014 JP 2014232996; 22.07.2015 JP 2015144911
(43) Date of publication of application: 27.09.2017
(73) Proprietor: Sekisui Chemical Co., Ltd., Osaka-shi, Osaka 530-8565 (JP)
(72) Inventor: TANIKAWA, Mitsuru, Mishima-gun Osaka 618-0021 (JP); WATANABE, Takashi, Mishima-gun Osaka 618-0021 (JP); FUJITA, Yusuke, Mishima-gun Osaka 618-0021 (JP); FUJITA, Yoshito, Mishima-gun Osaka 618-0021 (JP); UEDA, Michihisa, Mishima-gun Osaka 618-0021 (JP); INUI, Osamu, Mishima-gun Osaka 618-0021 (JP); TAKAHASHI, Ryosuke, Mishima-gun Osaka 618-0021 (JP); INOUE, Takanori, Mishima-gun Osaka 618-0021 (JP)
(74) Representative: Ter Meer Steinmeister & Partner
(86) International application number: PCT/JP2015/076678
(87) International publication number: WO 2016/080069

(56) References cited:
- EP-A1- 3 067 124
- WO-A1-2007/004569
- WO-A1-2011/058996
- WO-A1-2011/058998
- WO-A1-2013/154314
- WO-A1-2015/076235
- JP-A- 2007 258 425
- JP-A- 2010 264 689
- US-A1- 2012 248 634
- US-A1- 2013 208 064
- US-A1- 2013 244 401

## Description

### TECHNICAL FIELD

The present invention according to the appended claims relates to a photocurable and thermosetting adhesive for inkjet which is applied using an inkjet device to be used. Also, the present invention relates to a method for producing a semiconductor device using the adhesive, and an electronic component using the adhesive.

### BACKGROUND ART

A paste-like adhesive is mainly used as an adhesive for fixing a semiconductor element for joining between a semiconductor element and a support member such as a substrate. In recent years, downsizing of the support member to be used is also required with downsizing of semiconductor elements, and downsizing and improvement in performance of the semiconductor packages. For such a requirement, in the paste-like adhesive, problems of spreading and protrusion of the adhesive arise. Further, in the paste-like adhesive, it is difficult to control a thickness, and consequently, the semiconductor element is inclined to cause problems such as a defect of wire bonding. Therefore, joining using a conventional paste-like adhesive cannot adequately respond to recent semiconductor packages.

Further, in recent years, as described in Patent Document 1, an adhesive sheet having a film-like adhesive layer has been used.

In a joining method using the adhesive sheet, the adhesive sheet (adhesive layer) is bonded to a back surface of a semiconductor wafer first, and a dicing sheet is bonded to the other surface of the adhesive layer. Thereafter, the semiconductor wafer is singulated with the adhesive layer bonded to the semiconductor wafer by dicing to obtain a semiconductor element. Next, the semiconductor element with the adhesive layer is picked up and joined to the support member. Thereafter, undergoing assembling steps such as wire bonding, sealing and the like, a semiconductor device is obtained.

However, in the production of a semiconductor device using the adhesive sheet, since the adhesive sheet clings to a cutting blade at the time of dicing to deteriorate a cutting property, there is a problem that the semiconductor chip chips and a yield is reduced. Further, since a support member such as a substrate has a height difference due to a wiring pattern, voids easily remain in the height difference portion. The void causes the reliability to deteriorate.

Further, Patent Document 2 discloses an adhesive containing a radiation-polymerizable compound, a photo initiator, and a thermosetting resin. However, in such an adhesive, there is a problem that since the elastic modulus after photo-curing is high, the thickness accuracy of an adhesive layer is low in a substrate having a height difference in a wiring pattern, and voids are generated in the adhesive layer to decrease reliability.

### Related ART DOCUMENT

### PATENT DOCUMENT

Patent Document 1: JP 3-192178 A
Patent Document 2: WO 11/058998 A

### SUMMARY OF THE INVENTION

### PROBLEM TO BE SOLVED BY THE INVENTION

It is an object of the present invention to provide a photocurable and thermosetting adhesive for inkjet which is applied using an inkjet device to be used, and can increase the thickness accuracy of an adhesive layer formed by curing an adhesive and can further cause the adhesive layer to hardly generate voids. Further, it is also an object of the present invention to provide a method for producing a semiconductor device using the above-mentioned adhesive, and an electronic component using the adhesive.

EP 3 067 124 A1, US 2013/208064 A1, US 2012/248634 A1, US 2013/244401 A1, WO 2011/058996 A1, WO 2011/058998 A1, JP 2007 258425 A, WO 2013/154314 A1, WO 2007/004569 A1, JP 2010 264689 A, WO 2015/076235 A1 describe further adhesive compositions also for electronic articles.

### MEANS FOR SOLVING THE PROBLEM

According to the appended claims 1 to 12, the present invention relates to a photocurable and thermosetting adhesive for inkjet containing
(a) a photocurable compound having a (meth)acryloyl group,
(b) a thermosetting compound having an epoxy group or a thiirane group,
(c) a photocurable and thermosetting compound having a (meth)acryloyl group and having an epoxy group or a cyclic thioether group,
(d) a photopolymerization initiator, and
(e) a thermal curing agent,

wherein the photocurable compound (a) contains a photocurable and monofunctional compound having a (meth)acryloyl group and a photocurable and polyfunctional compound having two or more (meth)acryloyl groups, the thermosetting compound (b) contains a novolac type epoxy compound, a bisphenol type epoxy compound, alicyclic epoxy compound or glycidyl amine, and the photocurable and thermosetting compound (c) contains 4-hydroxybutyl(meth)acrylate glycidyl ether,
wherein the content of the photocurable and polyfunctional compound is at least 0.1 wt% and at most 30 wt% in 100 wt% of the total of the whole photocurable compound (a) and the photocurable and thermosetting compound (c)
and wherein the elastic modulus at 25°C of a B-staged adhesive is at least 5.0 × 102 Pa and at most 8.0 × 104 Pa when the B-staged adhesive is obtained by irradiating the adhesive with light of a cumulative light quantity of 1000 mJ/cm2 so that illumination at a wavelength of 365 nm is 100 mW/cm2.

In a specific aspect of the adhesive according to the present invention, the photocurable compound having a photocurable reactive group includes 2-ethylhexyl (meth)acrylate.

In a specific aspect of the adhesive according to the present invention, the viscosity at 25°C and at 10 rpm measured according to JIS K 2283 is at least 5 mPa·s and at most 1600 mPa·s.

In a specific aspect of the adhesive according to the present invention, the adhesive does not include or includes a solvent, and when the adhesive includes the solvent, the content of the solvent is 1 wt% or less.

In a specific aspect of the adhesive according to the present invention, the adhesive does not include or includes fillers, and when the adhesive includes the fillers, the content of the fillers is 1 wt% or less.

According to the present invention, provided is a method for producing a semiconductor device comprising an application step of applying the above-mentioned photocurable and thermosetting adhesive for inkjet onto the surface of a support member for mounting a semiconductor element or a semiconductor element using an inkjet device to form an adhesive layer; a step of allowing curing of the adhesive layer to proceed by light irradiation to form a B-staged adhesive layer; a step of laminating a semiconductor element on the surface opposite to a side of the support member or the semiconductor element of the B-staged adhesive layer; and a step of thermally curing the B-staged adhesive layer after the lamination of the semiconductor element.

According to the present invention, provided is a method for producing a semiconductor device comprising an application step of ejecting the above-mentioned photocurable and thermosetting adhesive for inkjet to the surface of a semiconductor wafer using an inkjet device to form an adhesive layer; a step of allowing curing of the adhesive layer to proceed by light irradiation to form a B-staged adhesive layer; a step of laminating a cover glass on the surface opposite to a side of the semiconductor wafer of the B-staged adhesive layer to prepare a laminate; a step of thermally curing the B-staged adhesive layer in the laminate; and a step of cutting the laminate after thermal curing.

In a specific aspect of the method for producing a semiconductor device according to the present invention, the elastic modulus at 25°C of the B-staged adhesive layer is set to at least 5.0 × 10² Pa and at most 8.0 × 10⁴ Pa.

In a specific aspect of the method for producing a semiconductor device according to the present invention, the inkjet device has an ink tank in which the photocurable and thermosetting adhesive for inkjet is stored; an ejection portion which is connected to the ink tank and from which the photocurable and thermosetting adhesive for inkjet is ejected; and a circulation channel portion connected to the ejection portion at its one end and connected to the ink tank at the other end, the inside of which the adhesive flows through, and in the application step, the photocurable and thermosetting adhesive for inkjet is applied while circulating it by transferring the photocurable and thermosetting adhesive for inkjet from the ink tank to the ejection portion, and then transferring the photocurable and thermosetting adhesive for inkjet not ejected from the ejection portion to the ink tank through the circulation channel portion in the inkjet device.

In a specific aspect of the method for producing a semiconductor device according to the present invention, a temperature of the photocurable and thermosetting adhesive for inkjet being circulated is 40°C or higher and 100°C or lower.

According to a broad aspect of the present invention, provided is an electronic component comprising a first electronic component main body, a second electronic component main body, and an adhesive layer making connection between the first electronic component main body and the second electronic component main body, and the adhesive layer is a cured product of the above-mentioned photocurable and thermosetting adhesive for inkjet.

In a specific aspect of the electronic component according to the present invention, the first electronic component main body is a support member for mounting a semiconductor element or a semiconductor element, and the second electronic component main body is a semiconductor element.

### EFFECT OF THE INVENTION

Since the photocurable and thermosetting adhesive for inkjet according to the present invention according to present claims 1 to 12 contains a photocurable compound, a thermosetting compound, a photopolymerization initiator, and a thermal curing agent, and the elastic modulus at 25°C of a B-staged adhesive is at least 5.0 × 10² Pa and at most 8.0 × 10⁴ Pa when the B-staged adhesive is obtained by irradiating the adhesive with light of a cumulative light quantity of 1000 mJ/cm² so that illumination at a wavelength of 365 nm is 100 mW/cm², the thickness accuracy of an adhesive layer formed by curing an adhesive can be increased and voids can be hardly generated in the adhesive layer when applying the photocurable and thermosetting adhesive for inkjet of the present invention using an inkjet device.

### BRIEF DESCRIPTION OF THE DRAWINGS

FIG. 1 is a front sectional view schematically showing an electronic component prepared using the photocurable and thermosetting adhesive for inkjet of an embodiment of the present invention.
FIG. 2 (a) to 2 (e) is a sectional view for explaining steps of a method for producing the electronic component shown in FIG. 1.
FIG. 3 is a schematic configuration diagram showing an example of an inkjet device used in a method for producing an electronic component shown in FIG. 2.
FIG. 4 is a schematic configuration diagram showing another example of an inkjet device used in the method for producing an electronic component shown in FIG. 2.
FIG. 5 is a front sectional view schematically showing a variation of the electronic component shown in FIG. 1.
FIG. 6 is a front sectional view schematically showing a first variation of an electronic component prepared using the photocurable and thermosetting adhesive for inkjet of an embodiment of the present invention.
FIG. 7 is a front sectional view schematically showing a second variation of an electronic component prepared using the photocurable and thermosetting adhesive for inkjet of an embodiment of the present invention.

### MODE FOR CARRYING OUT THE INVENTION

Hereinafter, the present invention will be described in detail.

A photocurable and thermosetting adhesive for inkjet (hereinafter, sometimes abbreviated to an adhesive) according to the present invention is applied using an inkjet device to be used. The adhesive according to the present invention differs from an adhesive applied by screen printing or an adhesive applied by a dispenser.

The adhesive according to the present invention is cured by light irradiation and heating to be used. The adhesive according to the present invention is preferably used by allowing curing to proceed by light irradiation, and then curing the adhesive by heating. The adhesive according to the present invention is a photocurable and thermosetting adhesive, and has photocurability and heat-curability. The adhesive according to the present invention differs from an adhesive performing only light curing or an adhesive performing only heat-curing.

The adhesive according to the present invention contains a photocurable compound (curable compound capable of being cured by light irradiation), a thermosetting compound (curable compound capable of being cured by heating), a photopolymerization initiator, and a thermal curing agent.

The B-staged adhesive is obtained by irradiating the adhesive of the present invention with light of a cumulative light quantity of 1000 mJ/cm² so that illumination at a wavelength of 365 nm is 100 mW/cm². In the present invention, the elastic modulus at 25°C of the B-staged adhesive is at least 5.0 × 10² Pa and at most 8.0 × 10⁴ Pa. In addition, the illumination was measured with "UIT-201" manufactured by USHIO INC.

In the adhesive of the present invention, since the above-mentioned constitution is provided, the thickness accuracy of an adhesive layer formed by curing an adhesive can be increased when applying the photocurable and thermosetting adhesive for inkjet of the present invention using an inkjet device and curing the adhesive. Moreover, it is possible to cause the adhesive layer to hardly generate voids. Further, in the present invention, hygroscopic property and cooling/heating cycle characteristics can be improved.

The elastic modulus at 25°C of the B-staged adhesive is preferably 5.0 × 10² Pa or more, more preferably 8.0 × 10² Pa or more, and preferably 8.0 × 10⁴ Pa or less and more preferably 5.0 × 10⁴ Pa or less. When the elastic modulus is the above-mentioned lower limit or more, displacement of the semiconductor chip hardly occurs. When the elastic modulus is the above-mentioned upper limit or less, an adhesive force after bonding the semiconductor chip or the like becomes improved, and generation of voids is suppressed.

The elastic modulus is measured at 25°C in the conditions of a measurement plate: parallel plates with a diameter of 8 mm and a frequency of 1 Hz using a viscoelasticity measurement apparatus ARES manufactured by TA Instruments Japan Inc. In addition, in the present specification, the elastic modulus means storage elastic modulus (G').

Since the adhesive according to the present invention is applied using the inkjet device, it is generally liquid at 25°C. The viscosity at 25°C and at 10 rpm of the adhesive is preferably 3 mPa·s or more, more preferably 5 mPa·s or more, furthermore preferably 10 mPa·s or more, moreover preferably 160 mPa·s or more, and preferably 2000 mPa•s or less, more preferably 1600 mPa·s or less and moreover preferably 1500 mPa·s or less. From the viewpoint of the further increase in the thickness accuracy of the adhesive layer and further causing the adhesive layer to hardly generate voids, the viscosity at 25°C and at 10 rpm of the adhesive is particularly preferably at least 160 mPa•s and at most 1600 mPa·s.

The viscosity is measured at 25°C according to JIS K 2283 using an E-type viscometer ("TVE-22L" manufactured by Toki Sangyo Co., Ltd.).

A method for producing a semiconductor device according to the present invention comprises an application step of applying the above-mentioned photocurable and thermosetting adhesive for inkjet onto the surface of a support member for mounting a semiconductor element or a semiconductor element using an inkjet device to form an adhesive layer; a step of allowing curing of the adhesive layer to proceed by light irradiation to form a B-staged adhesive layer; a step of laminating a semiconductor element on the surface opposite to a side of the support member or the semiconductor element of the B-staged adhesive layer; and a step of thermally curing the B-staged adhesive layer after the lamination of the semiconductor element.

Further, a method for producing a semiconductor device according to the present invention comprises an application step of ejecting the above-mentioned photocurable and thermosetting adhesive for inkjet to the surface of a semiconductor wafer using an inkjet device to form an adhesive layer; a step of allowing curing of the adhesive layer to proceed by light irradiation to form a B-staged adhesive layer; a step of laminating a cover glass on the surface opposite to a side of the semiconductor wafer of the B-staged adhesive layer to prepare a laminate; a step of thermally curing the B-staged adhesive layer in the laminate; and a step of cutting the laminate after thermal curing.

When the adhesive of the present invention is used, it is possible to increase the thickness accuracy of the adhesive layer and further cause the adhesive layer to hardly generate voids. Accordingly, the adhesive according to the present invention is able to be suitably used for the method for producing a semiconductor device of the present invention.

The adhesive is preferably ejected in a state of being warmed to 40°C or higher and 100°C or lower when ejecting the adhesive from an inkjet device. From the viewpoint of forming the adhesive layer with higher accuracy to cause the adhesive layer to hardly generate voids, it is preferred to apply the photocurable and thermosetting adhesive for inkjet while circulating the photocurable and thermosetting adhesive for inkjet.

The above-mentioned inkjet device preferably has an ink tank in which the adhesive is stored, an ejection portion connected to the ink tank from which the adhesive is ejected, and a circulation channel portion connected to the ejection portion at its one end and connected to the ink tank at the other end, the inside of which the adhesive flows through.

When the adhesive is applied, the adhesive is applied while circulating it by transferring the adhesive from the ink tank to the ejection portion, and then transferring the adhesive not ejected from the ejection portion to the ink tank through the circulation channel portion in the inkjet device. When the adhesive is applied while being circulated, the effect of the present invention is more effectively achieved. That is, it is possible to further increase the thickness accuracy of the adhesive layer and further cause the adhesive layer to hardly generate voids.

In the present invention, an adhesive layer having a large thickness can be formed with high accuracy. Further, in the present invention, even a multilayered adhesive layer can be finely formed with high accuracy.

Hereinafter, the present invention will become apparent from description of specific embodiments and examples of the present invention in reference to drawings.

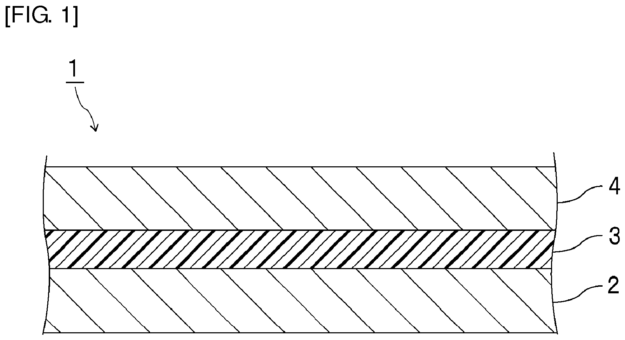

FIG. 1 is a front sectional view schematically showing an electronic component prepared using the photocurable and thermosetting adhesive for inkjet of an embodiment of the present invention.

The electronic component 1 shown in FIG. 1 includes a first electronic component main body 2, an adhesive layer 3 arranged on the surface of the first electronic component main body 2, and a second electronic component main body 4 arranged on the surface of the adhesive layer 3. The second electronic component main body 4 is arranged on a side opposite to a side of the first electronic component main body 2 of the adhesive layer 3. The first electronic component main body 2 is arranged on a first surface of the adhesive layer 3. The second electronic component main body 4 is arranged on a second surface opposite to the first surface of the adhesive layer 3. The adhesive layer 3 is an adhesive layer after photo-curing and thermal curing and a cured adhesive layer (cured product layer) . In order to form the adhesive layer 3, the photocurable and thermosetting adhesive for inkjet of an embodiment of the present invention is used. The photocurable and thermosetting adhesive for inkjet is applied using an inkjet device, curing of the adhesive proceeds by light irradiation, and then the adhesive is cured by heating to form an adhesive layer 3.

Specific examples of the electronic component main body include a circuit board, a semiconductor wafer, a semiconductor wafer after dicing (divided semiconductor wafer, semiconductor element), a cover glass, a capacitor, a diode, a printed circuit board, a flexible printed circuit board, a glass epoxy substrate and a glass board. The electronic component main body may be a support member for mounting a semiconductor element.

Since an adhesive layer formed with high accuracy is particularly required, the electronic component main body is preferably a circuit board, a cover glass, a semiconductor wafer, or a semiconductor wafer after dicing.

Since an adhesive layer formed with high accuracy is particularly required, the first electronic component main body is preferably a support member for mounting a semiconductor element or a semiconductor element, more preferably a circuit board or a semiconductor element, and moreover preferably a circuit board or a semiconductor wafer after dicing. Since an adhesive layer formed with high accuracy is particularly required, the second electronic component main body is preferably a semiconductor element, and more preferably a semiconductor wafer after dicing.

Since an adhesive layer formed with high accuracy is particularly required, it is preferred that the first electronic component main body is a circuit board or a semiconductor wafer after dicing, and the second electronic component main body is a semiconductor wafer after dicing, and more preferred that the first electronic component main body is a circuit board, and the second electronic component main body is a semiconductor wafer after dicing. The above-mentioned electronic component is preferably an electronic component for a semiconductor device.

The electronic component preferably includes a semiconductor element and is preferably a semiconductor device.

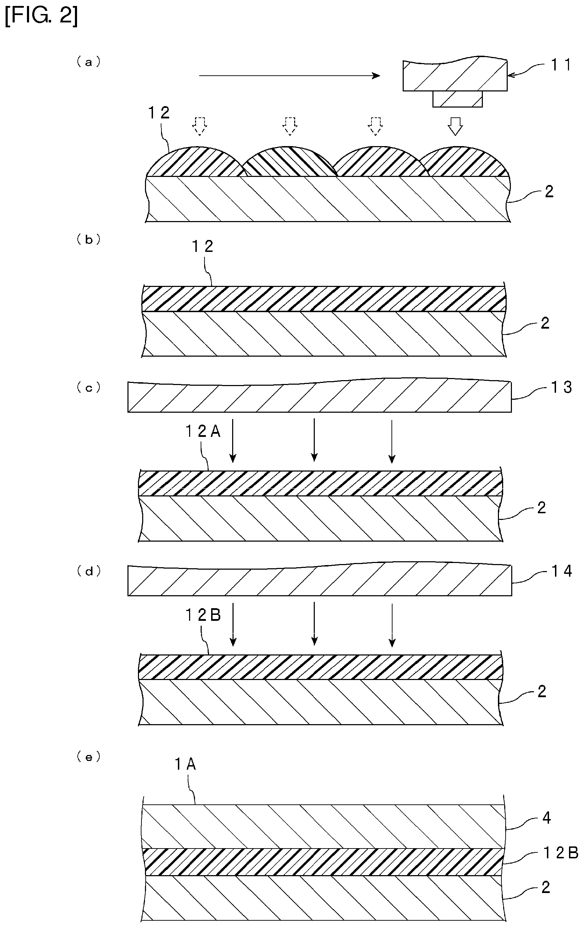

Hereinafter, an example of a method for producing the electronic component shown in FIG. 1 will be described in reference to FIG. 2(a) to 2(e).

First, as shown in FIG. 2(a), a photocurable and thermosetting adhesive for inkjet is applied onto the first electronic component main body 2 using an inkjet device 11 to form an adhesive layer 12 (application step). Herein, the adhesive is applied throughout the surface of the first electronic component main body 2. After the application of the adhesive, droplets of the adhesive are mixed with one another to form an adhesive layer 12 in a state shown in FIG. 2(b).

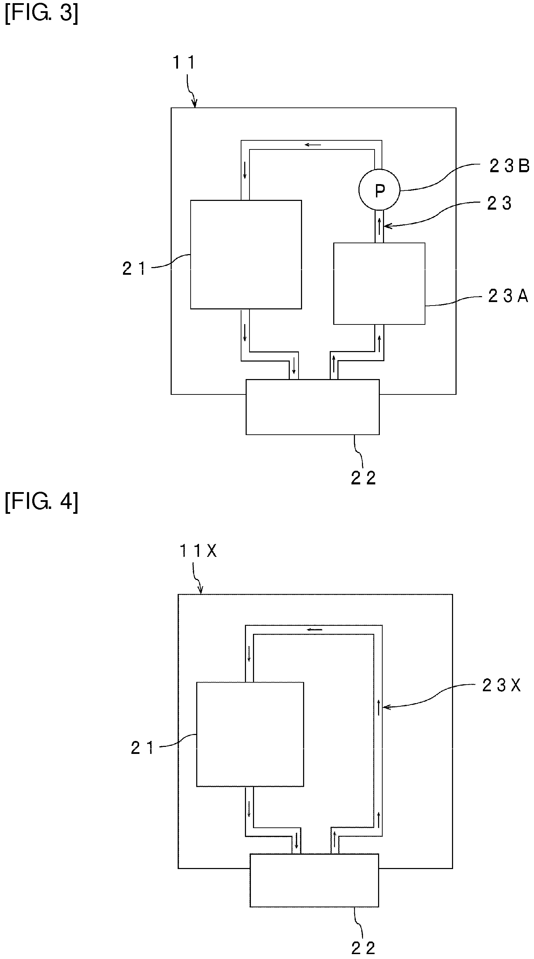

As shown in Fig. 3, the inkjet device 11 has the ink tank 21, the ejection portion 22, and the circulation channel portion 23 therein.

The circulation channel portion 23 has a buffer tank 23A and a pump 23B within the circulation channel portion 23. However, as with the inkjet device 11X as shown in Fig. 4, the circulation channel portion 23X does not have to have a buffer tank and a pump within the circulation channel portion 23X. The circulation channel preferably has the above-mentioned buffer tank within the circulation channel portion and preferably has the above-mentioned pump. Further, the circulation channel portion may have a flow velocimeter, a temperature indicator, a filter, a liquid level sensor and the like in addition to the buffer tank and the pump within the circulation channel portion.

The adhesive is stored in the ink tank 21. The adhesive is ejected from the ejection portion 22 (inkjet head). The ejection portion 22 includes an ejection nozzle. The ejection portion 22 is connected to the ink tank 21. The ink tank 21 and the ejection portion 22 are connected to each other with the channel interposed therebetween. One end of the circulation channel portion 23 is connected to the ejection portion 22 and the other end is connected to the ink tank 21. The adhesive flows through the inside of the circulation channel portion 23.

When a buffer tank 23A or a pump 23B is provided, the buffer tank 23A and the pump 23B are each preferably placed between the ejection portion 22 and the ink tank 21. The buffer tank 23A is placed at a position closer to the ejection portion 22 than the pump 23B. The pump 23B is placed at a position closer to the ink tank 21 than the buffer tank 23A. The adhesive is temporarily stored in the buffer tank 23A.

Examples of the ejection portion include inkjet heads of a thermal type, a bubble injection type, an electromagnetic valve type, and a piezo type. Examples of a circulation channel portion in the ejection portion include an end shooter type which is branched from a common circulation channel (manifold) to an ejection nozzle, and a side shooter type in which an ink is circulated through the ejection nozzle. From the viewpoint of enhancing an ejecting property of the adhesive to further increase the formation accuracy of a fine adhesive layer, it is preferred that the inkjet device is an inkjet device using an inkjet head of a piezo type, and the adhesive is applied by the action of a piezo element.

With respect to a method of circulating the adhesive, it is possible to employ a method of using an ink's own weight, or a method of using pressuring/depressuring of a pump or the like to circulate the adhesive. These methods may be used in combination of two or more thereof. Examples of the pump to be used include a non-pulsatile pump of a cylinder type, a propeller pump, a gear pump and a diaphragm pump. From the viewpoint of increasing circulation efficiency to further increase the formation accuracy of a fine adhesive layer, the circulation channel portion preferably includes a pump for transferring the adhesive in the circulation channel portion.

In an ejection nozzle of the ejection portion, it is preferred that the adhesive is maintained at an appropriate pressure and pressure fluctuation (pulsation) is low in the range of the appropriate pressure. When a pump or the like is used, a damper is preferably provided between the pump and the ejection portion in order to suppress the pulsation of the pump. Such a damper includes a buffer tank in which the adhesive is temporarily stored and a membrane type damper.

From the viewpoint of bringing the cured adhesive layer into higher accuracy, the circulation channel portion preferably includes a buffer tank in which the adhesive is temporarily stored within the circulation channel.

When the adhesive is circulated while being heated, a temperature of the adhesive can be adjusted by introducing a heater in the ink tank or by using a heater at the circulation channel portion.

When the adhesive is circulated while being heated, a temperature of the adhesive can be adjusted by introducing a heater in the ink tank 21 or by using a heater at the circulation channel portion 23 or 23X.

In the application step, in the inkjet device 11, the adhesive is transferred from the ink tank 21 to the ejection portion 22, and then the adhesive not ejected from the ejection portion 22 is transferred to the ink tank 21 through the circulation channel portion 23. Thereby, the adhesive is preferably applied while circulating it in the application step.

Next, as shown in FIGs. 2(b) and 2(c), after the application step, the adhesive layer 12 is irradiated with light from a first light irradiation part 13 to allow curing of the adhesive layer 12 to proceed (first light irradiation step). Thereby, an adhesive layer 12A having irradiated with light from a first light irradiation part 13 is formed. The adhesive layer 12A is a preliminary cured product and the B-staged adhesive layer. The elastic modulus at 25°C of this B-staged adhesive layer is preferably set to at least 5.0 × 10² Pa and at most 8.0 × 10⁴ Pa. When irradiated with light from a second light irradiation part 14 described later, a wavelength or irradiation intensity of irradiation light from the first light irradiation part 13 may be the same as or different from the wavelength or irradiation intensity of irradiation light from the second light irradiation part 14 described later. From the viewpoint of the further enhancement of curability of the adhesive layer, the irradiation intensity of irradiation light from the second light irradiation part 14 is preferably higher than that of irradiation light from the first light irradiation part 13. When the photocurable compound and the photocurable and thermosetting compound are used, it is preferred to implement the above-mentioned first light irradiation step and the second light irradiation step described later in order to control photocurability.

In addition, "the adhesive layer 12 is irradiated with light from a first light irradiation part 13 to allow curing of the adhesive layer 12 to proceed" includes allowing a reaction to proceed to make the adhesive thicker.

A device which emits light is not particularly limited, and examples thereof include a light-emitting diode generating ultraviolet light (UV-LED), a metal halide lamp, a high-pressure mercury lamp, and an ultra-high pressure mercury lamp. From the viewpoint of further increasing the formation accuracy of an adhesive layer, particularly, the UV-LED is preferably used for the first light irradiation part.

Next, as shown in FIGs. 2(c) and 2(d), after the first light irradiation step, the adhesive layer 12A having irradiated with light from the first light irradiation part 13 may be irradiated with light from the second light irradiation part 14 outside the first light irradiation part 13 to allow curing of the adhesive layer 12A to further proceed (second light irradiation step) . Thereby, an adhesive layer 12B having irradiated with light from the second light irradiation part 14 is formed. The adhesive layer 12B is a preliminary cured product and the B-staged adhesive layer. The elastic modulus at 25°C of the surface of this B-staged adhesive layer is preferably set to at least 5.0 × 10² Pa and at most 8.0 × 10⁴ Pa. In addition, it is preferred to set the elastic modulus at 25°C of the surface of the B-staged adhesive layer after the first light irradiation step among the B-staged adhesive layer after the second light irradiation step and the B-staged adhesive layer after the first light irradiation step to at least 5.0 × 10² Pa and at most 8.0 × 10⁴ Pa. It is more preferred to set the elastic moduli at 25°C of the surfaces of both of the B-staged adhesive layer after the second light irradiation step and the B-staged adhesive layer after the first light irradiation step to at least 5.0 × 10² Pa and at most 8.0 × 10⁴ Pa.

The second light irradiation step is preferably implemented prior to a lamination step described later, and preferably implemented prior to a heating step. From the viewpoint of bringing the cured adhesive layer into higher accuracy, it is preferred to implement the second light irradiation step. However, the second light irradiation step does not always have to be implemented, and after the first light irradiation step, the lamination step described later may be implemented without implementing the second light irradiation step.

Next, as shown in FIGs. 2 (d) and 2(e), after the second light irradiation step, a second electronic component main body 4 is arranged on the adhesive layer 12B having irradiated with light, and the first electronic component main body 2 is bonded to the second electronic component main body 4 with the adhesive layer 12B having irradiated with light interposed therebetween by application of pressure to obtain a primary laminate 1A (lamination step). In addition, when the second light irradiation step is not implemented after the first light irradiation step, a second electronic component main body 4 is arranged on the adhesive layer 12A having irradiated with light, and the first electronic component main body 2 is bonded to the second electronic component main body 4 with the adhesive layer 12A having irradiated with light interposed therebetween by application of pressure to obtain a primary laminate (lamination step).

Next, after the lamination step, the primary laminate 1A is heated, and thereby the adhesive layer 12B between the first electronic component main body 2 and the second electronic component main body 4 is cured to obtain an electronic component (heating step) . In this way, the electronic component 1 shown in FIG. 1 can be obtained.

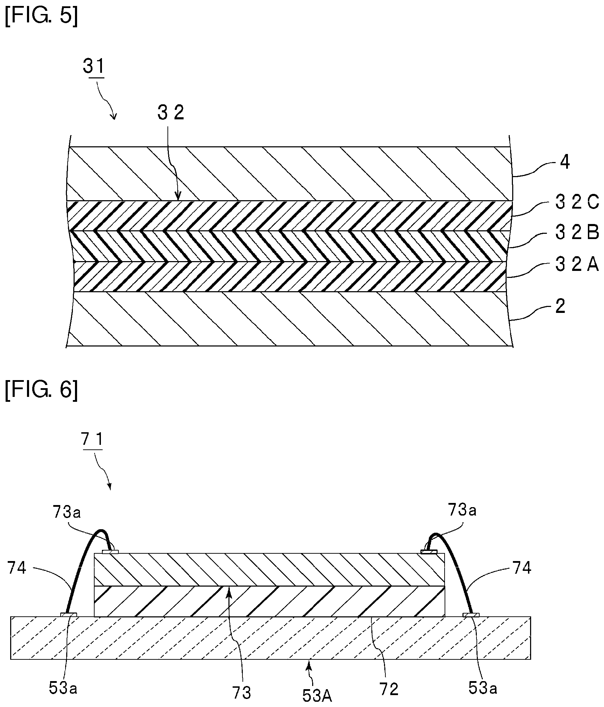

In addition, by repeating the application step and the first light irradiation step, the adhesive layer may be brought into a multilayer to form a multilayered adhesive layer. As shown in FIG. 5, an electronic component 31 provided with an adhesive layer 32 having a plurality of laminated adhesive layers 32A, 32B and 32C may be formed.

In the above-mentioned production method of an electronic component, from the viewpoint of enhancing an ejecting property and a transferring property of the adhesive to bring the cured adhesive layer into higher accuracy, a temperature of the adhesive which is circulated is preferably 30°C or higher, more preferably 40°C or higher, and preferably 120°C or lower and more preferably 100°C or lower.

From the viewpoint of bringing the cured adhesive layer into higher accuracy, a pressure applied in bonding the electronic component main bodies to each other in the lamination step is preferably 0.01 MPa or more, more preferably 0.05 MPa or more, and preferably 10 MPa or less and more preferably 8 MPa or less.

From the viewpoint of bringing the cured adhesive layer into higher accuracy, a temperature at the time of bonding the electronic component main bodies to each other in the lamination step is preferably 30°C or higher, more preferably 40°C or higher, and preferably 150°C or lower and more preferably 130°C or lower.

The adhesive has photocurability and heat-curability. The adhesive contains a photocurable compound, a thermosetting compound, a photopolymerization initiator, and a thermal curing agent. The adhesive preferably contains a photocurable and thermosetting compound (curable compound capable of being cured by both of light irradiation and heating). The adhesive preferably contains a curing accelerator.

Hereinafter, the components contained in the adhesive will be described in detail.

### (Photocurable Compound)

The photocurable compound is a compound having a photocurable reactive group. Examples of the photocurable compound include a curable compound having a (meth)acryloyl group, a curable compound having a vinyl group and a curable compound having a maleimide group. From the viewpoint of bringing the cured adhesive layer into higher accuracy, the photocurable reactive group of the photocurable compound is preferably a (meth)acryloyl group, and the photocurable compound preferably has one or more (meth) acryloyl groups. As the photocurable compound, only one type may be used, or a combination of at least two types may also be used.

In the present specification, the above-mentioned curable compound having a (meth)acryloyl group refers to a compound having at least one of a methacryloyl group and an acryloyl group.

As the photocurable compound, a polyfunctional compound (photoreactive compound) having two or more photocurable reactive groups (A1) may be used, or a monofunctional compound (photoreactive compound) having a photocurable reactive group (A2) may be used. From the viewpoint of bringing the cured adhesive layer into higher accuracy, the photocurable reactive group of the polyfunctional compound (A1) is preferably a (meth) acryloyl group. From the viewpoint of bringing the cured adhesive layer into higher accuracy, the photocurable reactive group of the monofunctional compound (A2) is preferably a (meth)acryloyl group.

According to appended claim 1, the adhesive includes, as the photocurable compound, the monofunctional compound having a (meth)acryloyl group (A2) and the polyfunctional compound having two or more (meth)acryloyl groups (A1).

Examples of the polyfunctional compound (A1) include a (meth)acrylic acid adduct of a polyhydric alcohol, a (meth) acrylic acid adduct of a modified product of a polyhydric alcohol with an alkylene oxide, urethane (meth)acrylate compounds and polyester (meth)acrylate compounds. Examples of the polyhydric alcohol include diethylene glycol, triethylene glycol, polyethylene glycol, dipropylene glycol, tripropylene glycol, polypropylene glycol, trimethylolpropane, cyclohexanedimethanol, tricyclodecanedimethanol, an alkylene oxide adduct of bisphenol A, and pentaerythritol.

The polyfunctional compound (A1) may be difunctional (meth)acrylate, may be trifunctional (meth) acrylate or may be tetra- or more functional (meth)acrylate.

Examples of the difunctional (meth)acrylate include 1,4-butanediol di(meth)acrylate, 1,6-hexanediol di(meth)acrylate, 1,9-nonane di(meth)acrylate, 1,10-decanediol di(meth)acrylate, neopentyl glycol di(meth)acrylate, 2,4-dimethyl-1,5-pentanediol di(meth)acrylate, butylethylpropanediol (meth)acrylate, ethoxylated cyclohexane methanol di(meth)acrylate, polyethylene glycol di(meth)acrylate, oligoethylene glycol di(meth)acrylate, ethylene glycol di(meth)acrylate, 2-ethyl-2-butyl-butanediol di(meth)acrylate, 2-ethyl-2-butyl-propanediol di(meth)acrylate, tricyclodecane di(meth)acrylate, and dipropylene glycol di(meth)acrylate.

Examples of the trifunctional (meth)acrylate include trimethylolpropane tri(meth)acrylate, trimethylolethane tri(meth)acrylate, alkylene oxide-modified tri(meth)acrylate of trimethylolpropane, pentaerythritol tri(meth)acrylate, dipentaerythritol tri(meth)acrylate, trimethylolpropane tri((meth) acryloyloxy propyl) ether, isocyanuric acid alkylene oxide-modified tri(meth)acrylate, propionic acid dipentaerythritol tri(meth)acrylate, tri((meth)acryloyloxyethyl)isocyanurate, and sorbitol tri(meth)acrylate.

Examples of the tetrafunctional (meth)acrylate include pentaerythritol tetra(meth)acrylate, sorbitol tetra(meth)acrylate, ditrimethylolpropane tetra(meth)acrylate, and propionic acid dipentaerythritol tetra(meth)acrylate.

Examples of the pentafunctional (meth)acrylate include sorbitol penta(meth)acrylate, and dipentaerythritol penta(meth)acrylate.

Examples of the hexafunctional (meth)acrylate include dipentaerythritol hexa(meth)acrylate, sorbitol hexa(meth)acrylate, and alkylene oxide-modified hexa(meth)acrylate of phosphazene.

The term "(meth)acrylate" refers to an acrylate and a methacrylate. The term "(meth)acrylic" refers to an acrylic and a methacrylic.

The polyfunctional compound (A1) is preferably a polyfunctional compound having a polycyclic skeleton or a urethane skeleton and having at least two (meth) acryloyl groups (A1). When the polyfunctional compound (A1) is used, the wet heat resistance of a cured product of the adhesive can be increased. Accordingly, reliability of electronic component can be enhanced. The polyfunctional compound (A1) may have the polycyclic skeleton or may have the urethane skeleton.

The polyfunctional compound (A1) is not particularly limited as long as it has the polycyclic skeleton or the urethane skeleton and also has at least two (meth) acryloyl groups. As the polyfunctional compound (A1), a conventional publicly known polyfunctional compound having a polycyclic skeleton or a urethane skeleton and also having two or more (meth)acryloyl groups can be used. The polymerization of the polyfunctional compound (A1) proceeds to cure the polyfunctional compound (A1) by the irradiation with light since the polyfunctional compound (A1) has at least two (meth)acryloyl groups. As the polyfunctional compound (A1), only one type may be used, or a combination of at least two types may also be used.

Specific examples of the polyfunctional compound having the polycyclic skeleton and also having at least two (meth)acryloyl groups include tricyclodecanedimethanol di(meth)acrylate, isobornyldimethanol di(meth)acrylate and dicyclopentenyldimethanol di(meth)acrylate. Particularly, from the viewpoint of the further enhancement of wet heat resistance of the cured product, the polyfunctional compound (A1) is preferably tricyclodecanedimethanol di(meth) acrylate.

The term "polycyclic skeleton" as used in the polyfunctional compound (A1) and a monofunctional compound (A2) as described below refers to a structure having contiguous multiple cyclic skeletons. Specifically, the polycyclic skeleton is a skeleton in which two or more rings are combined into one in the form of each sharing two or more atoms and a skeleton having a condensed ring. The polycyclic skeleton is not, for example, a skeleton in which an alkylene group is present between two rings. Examples of the polycyclic skeleton in the polyfunctional compound (A1) and the monofunctional compound (A2) include a polycyclic alicyclic skeleton and a polycyclic aromatic skeleton.

Examples of the polycyclic alicyclic skeleton include a bicycloalkane skeleton, a tricycloalkane skeleton, a tetracycloalkane skeleton and an isobornyl skeleton.

Examples of the polycyclic aromatic skeleton include a naphthalene ring skeleton, an anthracene ring skeleton, a phenanthrene ring skeleton, a tetracene ring skeleton, a chrysene ring skeleton, a triphenylene ring skeleton, a tetraphene ring skeleton, a pyrene ring skeleton, a pentacene ring skeleton, a picene ring skeleton and a perylene ring skeleton.

From the viewpoint of the further enhancement of insulation reliability and adhesion reliability, the photocurable compound preferably includes a photocurable compound having a dicyclopentadiene skeleton.

The polyfunctional compound having the urethane skeleton and having two or more (meth) acryloyl groups is not particularly limited, and it can be obtained, for example, by the following method. A polyol is reacted with difunctional or more isocyanate, and a (meth)acrylic monomer having an alcohol or an acid group is further reacted with a residual isocyanate group. A (meth) acrylic monomer having a hydroxyl group may be reacted with the difunctional or more isocyanate. Specifically, for example, 1 mole of trimethylolpropane and 3 mole of isophorone diisocyanate are reacted under the catalytic influence of a Sn-based catalyst. The urethane-modified (meth)acrylic compound can be obtained by reacting the isocyanate group remaining in the resulting compound with hydroxyethyl acrylate which is an acrylic monomer having 2 mole of a hydroxyl group.

The above-mentioned polyol is not particularly limited, and examples thereof include ethylene glycol, glycerin, sorbitol, trimethylolpropane, and (poly)propylene glycol.

The isocyanate is not particularly limited as long as it is difunctional or more. Examples of the above-mentioned isocyanates include isophorone diisocyanate, 2,4-trylene diisocyanate, 2,6-trylene diisocyanate, hexamethylene diisocyanate, trimethylhexamethylene diisocyanate, 4,4'-diphenylmethane diisocyanate (MDI), hydrogenated MDI, polymeric MDI, 1,5-naphthalene diisocyanate, norbornane diisocyanate, tolidine diisocyanate, xylylene diisocyanate (XDI), hydrogenated XDI, lysine diisocyanate, triphenylmethane triisocyanate, tris(isocyanatophenyl)thiophosphate, tetramethylxylene diisocyanate, and 1,6,10-undecane triisocyanate.

Specific examples of the monofunctional compound (A2) include methyl (meth)acrylate, ethyl (meth)acrylate, n-propyl (meth)acrylate, i-propyl (meth)acrylate, n-butyl (meth)acrylate, i-butyl (meth)acrylate, sec-butyl (meth)acrylate, t-butyl (meth)acrylate, 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, allyl (meth)acrylate, benzyl (meth)acrylate, cyclohexyl (meth)acrylate, phenyl (meth)acrylate, 2-methoxyethyl (meth)acrylate, 2-phenoxyethyl (meth)acrylate, methoxydiethylene glycol (meth)acrylate, methoxytriethylene glycol (meth)acrylate, methoxypropylene glycol (meth)acrylate, methoxydipropylene glycol (meth)acrylate, isobornyl (meth)acrylate, dicyclopentadienyl (meth)acrylate, 2-hydroxy-3-phenoxypropyl (meth)acrylate, glycerol mono(meth)acrylate, 2-ethylhexyl (meth)acrylate, dihydroxycyclopentadienyl (meth)acrylate, dicyclopentenyl (meth)acrylate, dicyclopentenyloxyethyl (meth)acrylate, dicyclopentanyl (meth)acrylate, naphthyl (meth)acrylate, rauryl (meth)acrylate, and stearyl (meth)acrylate.

From the viewpoint of the further increase in the thickness accuracy of the adhesive layer and further causing the adhesive layer to hardly generate voids, the photocurable compound preferably includes a photocurable compound having two or more photocurable reactive groups.

From the viewpoint of the further increase in the thickness accuracy of the adhesive layer and further causing the adhesive layer to hardly generate voids, the photocurable compound preferably includes a photocurable compound having a photocurable reactive group, and more preferably includes a photocurable compound having a photocurable reactive group and a photocurable compound having two or more photocurable reactive groups.

The photocurable reactive group is a (meth)acryloyl group.

From the viewpoint of the further increase in thickness accuracy of the cured adhesive layer, the photocurable compound having one of the photocurable reactive group preferably contains 2-ethylhexyl (meth)acrylate.

From the viewpoint of bringing the cured adhesive layer into higher accuracy, the content of the photocurable compound is preferably 10 wt% or more, more preferably 20 wt% or more, and preferably 80 wt% or less and more preferably 70 wt% or less in 100 wt% of the adhesive. From the viewpoint of the further increase in the thickness accuracy of the adhesive layer and further causing the adhesive layer to hardly generate voids, the content of the photocurable compound is particularly preferably at least 10 wt% and at most 80 wt% in 100 wt% of the adhesive.

From the viewpoint of the further increase in the thickness accuracy of the adhesive layer and further causing the adhesive layer to hardly generate voids, the content of the photocurable compound having two or more photocurable reactive groups is 0.1 wt% or more, more preferably 0.5 wt% or more, and preferably 100 wt% (total amount) or less, more 30 wt% or less and moreover preferably 20 wt% or less in 100 wt% of the total of the photocurable compound when the adhesive does not include a photocurable and thermosetting compound described later and in 100 wt% of the total of the whole photocurable compound and the photocurable and thermosetting compound when the adhesive includes the photocurable and thermosetting compound.

From the viewpoint of the further increase in the thickness accuracy of the adhesive layer and further causing the adhesive layer to hardly generate voids, the content of the photocurable compound having a photocurable reactive group is preferably 1 wt% or more, more preferably 10 wt% or more, and preferably 100 wt% (total amount) or less, more preferably 99 wt% or less and moreover preferably 90 wt% or less in 100 wt% of the total of the photocurable compound when the adhesive does not include a photocurable and thermosetting compound described later and in 100 wt% of the total of the whole photocurable compound and the photocurable and thermosetting compound when the adhesive includes the photocurable and thermosetting compound.

### (Photocurable and Thermosetting Compound)

From the viewpoint of further increasing the thickness accuracy of the adhesive layer, further causing the adhesive layer to hardly generate voids, and improving the reliability of a cooling/heating cycle or the like, the adhesive preferably includes the photocurable and thermosetting compound. Examples of the photocurable and thermosetting compound include compounds having various photocurable functional groups (photocurable reactive group) and various thermosetting functional groups. From the viewpoint of bringing the cured adhesive layer into higher accuracy, the photocurable reactive group of the photocurable and thermosetting compound is preferably a (meth)acryloyl group. According to claim 1, the photocurable and thermosetting compound has a (meth)acryloyl group and a cyclic thioether group, or has a (meth)acryloyl group and an epoxy group. The photocurable and thermosetting compound may have a cyclic thioether group. As the photocurable and thermosetting compound, only one type may be used, or a combination of at least two types may also be used.

The photocurable and thermosetting compound is not particularly limited, and examples thereof include a compound having a (meth)acryloyl group and an epoxy group, a partially (meth)acrylated product of an epoxy compound, and a urethane-modified (meth)acrylic epoxy compound.

The compound having a (meth)acryloyl group and an epoxy group contains 4-hydroxybutyl (meth)acrylate glycidyl ether.

The partially (meth)acrylated product of an epoxy compound can be obtained by reacting the epoxy compound with a (meth)acrylic acid in the presence of a catalyst according to a normal method. Examples of an epoxy compound capable of being used for the partially (meth) acrylated product of an epoxy compound include novolac type epoxy compounds, bisphenol type epoxy compounds. Examples of the novolac type epoxy compounds include phenol novolac type epoxy compounds, cresol novolac type epoxy compounds, biphenyl novolac type epoxy compounds, trisphenol novolac type epoxy compounds, and dicyclopentadiene novolac type epoxy compounds. Examples of the bisphenol type epoxy compounds include a bisphenol A epoxy compound, a bisphenol F epoxy compound, a 2,2'-diallylbisphenol A epoxy compound, a hydrogenated bisphenol epoxy compound, and a polyoxypropylene bisphenol A epoxy compound. It is possible to obtain an epoxy compound having a desired acrylation ratio by appropriately changing a mixing rate of an epoxy compound and a (meth) acrylic acid. The mixing rate of carboxylic acid per 1 equivalent of an epoxy group is preferably 0.1 equivalent or more, more preferably 0.2 equivalent or more, and preferably 0.7 equivalent or less and more preferably 0.5 equivalent or less.

The urethane-modified (meth)acrylic epoxy compound can be obtained, for example, by the following method. A polyol is reacted with difunctional or more isocyanate, and a (meth)acrylic monomer having an acid group and glycidol are further reacted with a residual isocyanate group. Or, a (meth) acrylic monomer having a hydroxyl group and glycidol may be reacted with the difunctional or more isocyanate without using a polyol. Or, the urethane-modified (meth) acrylic epoxy compound can also be obtained by reacting a (meth)acrylate monomer having an isocyanate group with glycidol. Specifically, for example, first, 1 mole of trimethylolpropane and 3 mole of isophorone diisocyanate are reacted under the catalytic influence of a Sn-based catalyst. The urethane-modified (meth)acrylic epoxy compound can be obtained by reacting the isocyanate group remaining in the resulting compound with hydroxyethyl acrylate which is an acrylic monomer having a hydroxyl group and glycidol which is epoxy having a hydroxyl group.

The above-mentioned polyol is not particularly limited, and examples thereof include ethylene glycol, glycerin, sorbitol, trimethylolpropane, and (poly)propylene glycol.

The isocyanate is not particularly limited as long as it is difunctional or more. Examples of the above-mentioned isocyanates include isophorone diisocyanate, 2,4-trylene diisocyanate, 2,6-trylene diisocyanate, hexamethylene diisocyanate, trimethylhexamethylene diisocyanate, 4,4'-diphenylmethane diisocyanate (MDI), hydrogenated MDI, polymeric MDI, 1,5-naphthalene diisocyanate, norbornane diisocyanate, tolidine diisocyanate, xylylene diisocyanate (XDI), hydrogenated XDI, lysine diisocyanate, triphenylmethane triisocyanate, tris(isocyanatophenyl)thiophosphate, tetramethylxylene diisocyanate, and 1,6,10-undecane triisocyanate.

The above-mentioned compound having a (meth)acryloyl group and a cyclic thioether group can be obtained, for example, by converting the epoxy group of the above-mentioned compound having a (meth)acryloyl group and an epoxy group to a cyclic thioether group. As a method of converting the epoxy group to the cyclic thioether group, a method is preferred in which a solution containing the compound having a (meth) acryloyl group and an epoxy group is continuously or intermittently added to a first solution containing a sulfurizing agent, and then a second solution containing a sulfurizing agent is further continuously or intermittently added. The above-mentioned epoxy group can be converted to a cyclic thioether group by this method.

Examples of the sulfurizing agent include thiocyanates, thioureas, phosphine sulfide, dimethylthioformamide and N-methylbenzothiazole-2-thione. Examples of the thiocyanates include sodium thiocyanate, potassium thiocyanate and sodium thiocyanate.

From the viewpoint of the further increase in the thickness accuracy of the cured adhesive layer, the photocurable and thermosetting compound contains 4-hydroxybutyl (meth)acrylate glycidyl ether, and more preferably contains 4-hydroxybutyl acrylate glycidyl ether.

From the viewpoint of bringing the cured adhesive layer into higher accuracy, the content of the photocurable and thermosetting compound is preferably 0.5 wt% or more, more preferably 1 wt% or more, and preferably 80 wt% or less and more preferably 70 wt% or less in 100 wt% of the adhesive.

From the viewpoint of bringing the cured adhesive layer into higher accuracy, the total content of the photocurable compound and the photocurable and thermosetting compound is preferably 10 wt% or more, more preferably 20 wt% or more, and preferably 80 wt% or less and more preferably 70 wt% or less in 100 wt% of the adhesive.

### (Thermosetting Compound)

Examples of the thermosetting compound include a thermosetting compound having an epoxy group or a thiirane group, and is also preferably a thermosetting compound having an epoxy group (epoxy compound). The thermosetting compound may be a thermosetting compound having a thiirane group. From the viewpoint of bringing the cured adhesive layer into higher accuracy, it is preferred that the thermosetting compound is a thermosetting compound having an epoxy group or a thiirane group, and the photocurable and thermosetting compound is a photocurable and thermosetting compound having a (meth)acryloyl group. As the thermosetting compound, only one type may be used, or a combination of at least two types may also be used.

The above-mentioned epoxy compound is not particularly limited, and examples thereof include novolac type epoxy compounds, bisphenol type epoxy compounds. Examples of the novolac type epoxy compounds include phenol novolac type epoxy compounds, cresol novolac type epoxy compounds, biphenyl novolac type epoxy compounds, trisphenol novolac type epoxy compounds, and dicyclopentadiene novolac type epoxy compounds. Examples of the bisphenol type epoxy compounds include a bisphenol A epoxy compound, a bisphenol F epoxy compound, a 2,2'-diallylbisphenol A epoxy compound, a hydrogenated bisphenol epoxy compound, and a polyoxypropylene bisphenol A epoxy compound. Further, examples of the epoxy compound in addition to these include alicyclic epoxy compound and glycidyl amines.

The thermosetting compound having a thiirane group can be obtained, for example, by converting an epoxy group of the epoxy compound having an epoxy group to a thiirane group. As a method of converting the epoxy group to the thiirane group, a method is preferred in which a solution containing the epoxy compound having an epoxy group is continuously or intermittently added to a first solution containing a sulfurizing agent, and then a second solution containing a sulfurizing agent is further continuously or intermittently added. The above-mentioned epoxy group can be converted to a thiirane group by this method.

Examples of the sulfurizing agent include thiocyanates, thioureas, phosphine sulfide, dimethylthioformamide and N-methylbenzothiazole-2-thione. Examples of the thiocyanates include sodium thiocyanate, potassium thiocyanate and sodium thiocyanate.

From the viewpoint of forming the adhesive layer with higher accuracy to cause the adhesive layer to hardly generate voids, the thermosetting compound preferably has an aromatic skeleton.

From the viewpoint of bringing the cured adhesive layer into higher accuracy, the content of the thermosetting compound is preferably 10 wt% or more, more preferably 20 wt% or more, and preferably 80 wt% or less and more preferably 70 wt% or less in 100 wt% of the adhesive.

### (Photopolymerization Initiator)

Example of a photopolymerization initiator includes a photo-radical polymerization initiator, a photo-cationic polymerization initiator or the like. The photopolymerization initiator is preferably the photo-radical polymerization initiator. As the photopolymerization initiator, only one type may be used, or a combination of at least two types may also be used.

The photo-radical polymerization initiator is not particularly limited. The photo-radical polymerization initiator is a compound which can generate radial by light irradiation to initiate a radical polymerization reaction. Specific examples of the photo-radical polymerization initiator include benzoin compounds such as benzoin, benzoin methyl ether, benzoin ethyl ether, and benzoin isopropyl ether; alkyl phenone compounds such as 2-hydroxy-2-methyl-1-phenyl-propan-1-one; acetophenone compounds such as acetophenone, 2,2-dimethoxy-2-phenyl acetophenone, 2,2-diethoxy-2-phenyl acetophenone and 1, 1-dichloroacetophenone; aminoacetophenone compounds such as 2-methyl-1-[4-(methylthio) phenyl]-2-morpholino propan-1-one, 2-benzyl-2-dimethylamino-1-(4-morpholinophenyl)-butan-1-one, 2-benzyl-2-dimethylamino-1-(4-morpholinophenyl)-butanone-1, 2-(dimethylamino)-2-[(4-methylphenyl)methyl]-1-[4-(4-morpho linyl)phenyl]-1-butanone and N,N-dimethylaminoacetophenone; anthraquinone compounds such as 2-methyl anthraquinone, 2-ethylanthraquinone and 2-t-butylanthraquinone; thioxanthone compounds such as 2,4-dimethylthioxanthone, 2,4-diethylthioxanthone, 2-chlorothioxanthone and 2,4-diisopropylthioxanthone; ketal compounds such as acetophenone dimethyl ketal and benzyl dimethyl ketal; acylphosphine oxide compounds such as 2,4,6-trimethylbenzoyldiphenylphosphine oxide and bis(2,4,6-trimethylbenzoyl)phenylphosphine oxide; oxime ester compounds such as 1,2-octanedione, 1-[4-(phenylthio)-2-(o-benzoyl oxime)], ethanone, and 1-[9-ethyl-6-(2-methyl benzoyl)-9H-carbazole-3-yl]-1-(o-acetyloxime); and titanocene compounds such as bis(cyclopentadienyl) diphenyl titanium, bis(cyclopentadienyl) dichloro titanium, bis(cyclopentadienyl)-bis(2,3,4,5,6-pentafluorophenyl)-tita nium and bis(cyclopentadienyl)-bis(2,6-difluoro-3-(pyrrol-1-yl)pheny l)-titanium. As the photo-radical polymerization initiator, only one type may be used, or a combination of at least two types may also be used.

A photopolymerization initiation aid may be used together with the photo-radical polymerization initiator. Examples of the photopolymerization initiation aid include N,N-dimethylaminobenzoic acid ethyl ester, N,N-dimethylaminobenzoic acid isoamyl ester, pentyl-4-dimethylaminobenzoate, triethylamine and triethanolamine. A photopolymerization initiation aid other than the above-mentioned compounds may also be used. As the photopolymerization initiation aid, only one type may be used, or a combination of at least two types may also be used.

Further, a titanocene compound such as CGI-784 (Ciba Specialty Chemicals Inc.) which has absorption in a visible region may be used for the purpose of accelerating the photo-reaction.

The photo-cationic polymerization initiator is not particularly limited, and examples thereof include a sulfonium salt, an iodonium salt, a metallocene compound and benzoin tosylate. As the photo-cationic polymerization initiator, only one type may be used, or a combination of at least two types may also be used.

The content of the photopolymerization initiator is preferably 0.1 wt% or more, more preferably 0.2 wt% or more, and preferably 10 wt% or less and more preferably 5 wt% or less in 100 wt% of the adhesive.

### (Thermal Curing Agent)

Examples of the thermal curing agent include an organic acid, an amine compound, an amide compound, a hydrazide compound, an imidazole compound, an imidazoline compound, a phenol compound, a urea compound, a polysulfide compound and an acid anhydride. As the thermal curing agent, a modified polyamine compound such as an amine-epoxy adduct may be used. A thermal curing agent other than the above-mentioned compounds may also be used. As the thermal curing agent, only one type may be used, or a combination of at least two types may also be used.

The amine compound means a compound having one or more primary to tertiary amino groups. Examples of the amine compound include (1) aliphatic polyamines, (2) alicyclic polyamines, (3) aromatic polyamines, (4) hydrazide, and (5) guanidine derivatives. In addition, it is also possible to use adducts, such as an epoxy-compound-added polyamine (reaction product between an epoxy compound and a polyamine), a Michael-added polyamine (reaction product between α,β-unsaturated ketone and a polyamine), a Mannich-added polyamine (condensate of a polyamine, formalin, and phenol), a thiourea-added polyamine (reaction product between thiourea and a polyamine), and a ketone-blocked polyamine (reaction product between a ketone compound and a polyamine [ketimine]).

Examples of the above (1) aliphatic polyamines include diethylenetriamine, triethylenetetramine, tetraethylenepentamine, and diethylamino propylamine.

Examples of the above (2) alicyclic polyamines include menthanediamine, isophoronediamine, N-aminoethylpiperazine, 3,9-bis(3-aminopropyl)-2,4,8,10-tetraoxaspiro(5,5)undecane adduct, bis(4-amino-3-methylcyclohexyl)methane, and bis(4-aminocyclohexyl)methane.

Examples of the above (3) aromatic polyamines include m-phenylenediamine, p-phenylenediamine, o-xylenediamine, m-xylenediamine, p-xylenediamine, 4,4-diaminodiphenylmethane, 4,4-diaminodiphenylpropane, 4,4-diaminodiphenylsulfone, 4,4-diaminodicyclohexane, bis(4-aminophenyl)phenylmethane, 1,5-diaminonaphthalene, 1,1-bis(4-aminophenyl)cyclohexane, 2,2-bis[(4-aminophenoxy)phenyl]propane, bis[4-(4-aminophenoxy)phenyl]sulfone, 1,3-bis(4-aminophenoxy)benzene, 4,4-methylene-bis(2-chloroaniline), and 4,4-diaminodiphenylsulfone.

Examples of the above (4) hydrazides include carbodihydrazide, adipic acid dihydrazide, sebacic acid dihydrazide, dodecanedioic acid dihydrazide, and isophthalic acid dihydrazide.

Examples of the above (5) guanidine derivatives include dicyandiamide, 1-o-tolyldiguanide, α-2,5-dimethylguanide, α,ω-diphenyldiguanide, α,α-bisguanyl guanidino diphenyl ether, p-chlorophenyldiguanide, α,α-hexamethylene bis[ω-(p-chlorophenol)]diguanide, phenyldiguanide oxalate, acetylguanidine, and diethylcyanoacetylguanidine.

The above-mentioned phenolic compound includes polyhydric phenolic compounds. Examples of the polyhydric phenolic compounds include phenol, cresol, ethylphenol, butylphenol, octylphenol, bisphenol A, tetrabromobisphenol A, bisphenol F, bisphenol S, 4,4'-biphenylphenol, a naphthalene skeleton-containing phenol novolac resin, a xylylene skeleton-containing phenol novolac resin, a dicyclopentadiene skeleton-containing phenol novolac resin, and a fluorene skeleton-containing phenol novolac resin.

Examples of the above-mentioned acid anhydrides include phthalic anhydride, tetrahydrophthalic anhydride, hexahydrophthalic anhydride, methyltetrahydrophthalic anhydride, methylnadic anhydride, dodecylsuccinic anhydride, chlorendic anhydride, pyromellitic dianhydride, benzophenone tetracarboxylic anhydride, methylcyclohexene tetracarboxylic anhydride, trimellitic anhydride, and polyazelaic anhydride.

The content of the thermal curing agent is preferably 1 wt% or more, more preferably 5 wt% or more, and preferably 60 wt% or less and more preferably 50 wt% or less in 100 wt% of the adhesive.

### (Curing Accelerator)

Examples of the above-mentioned curing accelerators include tertiary amine, imidazole, quaternary ammonium salts, quaternary phosphonium salts, organic metal salts, phosphorus compounds, and urea compounds.

The content of the curing accelerator is preferably 0.01 wt% or more, more preferably 0.1 wt% or more, and preferably 10 wt% or less and more preferably 5 wt% or less in 100 wt% of the adhesive.

### (Solvent)

The adhesive does not include or includes a solvent. The adhesive may include a solvent or does not have to include a solvent. From the viewpoint of the further increase in the thickness accuracy of the adhesive layer and further causing the adhesive layer to hardly generate voids, a lower content of the solvent in the adhesive is preferred.

The solvent includes water and an organic solvent. Particularly, from the viewpoint of the further enhancement of removability of a residual material, the organic solvent is preferred. Examples of the organic solvent include alcohols such as ethanol; ketones such as acetone, methyl ethyl ketone and cyclohexanone; aromatic hydrocarbons such as toluene, xylene and tetramethylbenzene; glycol ethers such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether and tripropylene glycol monomethyl ether; esters such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate and propylene carbonate; aliphatic hydrocarbons such as octane and decane; and petroleum base solvents such as petroleum ether and naphtha.

When the adhesive includes the solvent, the content of the solvent is preferably 5 wt% or less, more preferably 1 wt% or less, and moreover preferably 0.5 wt% or less in 100 wt% of the adhesive.

### (Filler)

The adhesive does not include or includes fillers. The adhesive may include the fillers or does not have to include the fillers. From the viewpoint of the further increase in the thickness accuracy of the adhesive layer and further causing the adhesive layer to hardly generate voids, a lower content of the filler in the adhesive is preferred. Moreover, a lower content of the fillers in the adhesive enables to suppress the occurrence of defective ejection of an inkjet device.

Examples of a material of the filler include silica, talc, clay, mica, hydrotalcite, alumina, magnesium oxide, aluminum hydroxide, aluminum nitride and boron nitride.

When the adhesive includes the filler, the content of the filler is preferably 5 wt% or less, more preferably 1 wt% or less, and moreover preferably 0.5 wt% or less in 100 wt% of the adhesive.

### (Other Components)

The adhesive may include other components. Other components are not particularly limited, and examples thereof include adhesion aids such as a coupling agent, pigment, dye, a levelling agent, an antifoaming agent and a polymerization inhibitor.

### (Specific Example of Electronic Component)

Hereinafter, other specific example of an electronic component prepared using the photocurable and thermosetting adhesive for inkjet of an embodiment of the present invention will be described.

FIG. 6 is a front sectional view schematically showing a first variation of an electronic component prepared using the photocurable and thermosetting adhesive for inkjet of an embodiment of the present invention.

The semiconductor device 71 shown in FIG. 6 is an electronic component. The semiconductor device 71 includes a substrate 53A, an adhesive layer 72 and a first semiconductor wafer 73. The substrate 53A has a first connection terminal 53a on an upper surface of the substrate. The first semiconductor wafer 73 has a connection terminal 73a on an upper surface of the first semiconductor wafer. The substrate 53A is formed in the same manner as in a substrate 53 described later except for not providing the second connection terminal 53b.

A first semiconductor wafer 73 is laminated on the substrate 53A with the adhesive layer 72 interposed therebetween. The adhesive layer 72 is formed by photo-curing and thermally curing the adhesive. The adhesive layer 72 is a cured product of the adhesive.

The first semiconductor wafer 73 has a connection terminal 73a on an upper surface of the first semiconductor wafer. A wiring 74 is led-out from the connection terminal 73a. The connection terminal 73a is electrically connected to the first connection terminal 53a by the wiring 74.

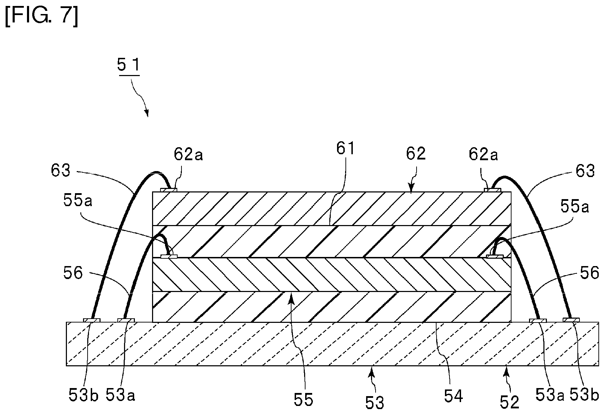

FIG. 7 is a front sectional view schematically showing a second variation of an electronic component prepared using the photocurable and thermosetting adhesive for inkjet of an embodiment of the present invention.

The semiconductor device 51 shown in FIG. 7 is an electronic component. The semiconductor device 51 includes a laminate structure 52. The laminate structure 52 has a substrate 53, an adhesive layer 54 and a second semiconductor wafer 55 laminated on the substrate 53 with the adhesive layer 54 interposed therebetween. The second semiconductor wafer 55 is arranged on the substrate 53. The second semiconductor wafer 55 is indirectly laminated on the substrate 53. In a planar view, the substrate 53 is larger than the second semiconductor wafer 55. The substrate 53 has a region extending sideward out of the second semiconductor wafer 55.

The adhesive layer 54 is formed, for example, by curing a curable composition. A curable composition layer before curing which uses a curable composition may have tackiness. A curable composition sheet may be used for forming the curable composition layer before curing.

The substrate 53 has a first connection terminal 53a on an upper surface of the substrate. The second semiconductor wafer 55 has a connection terminal 55a on an upper surface of the second semiconductor wafer. A wiring 56 is led-out from the connection terminal 55a. One end of the wiring 56 is connected to the connection terminal 55a provided on the second semiconductor wafer 55. The other end of the wiring 56 is connected to a first connection terminal 53a provided on the substrate 53. The connection terminal 55a is electrically connected to the first connection terminal 53a by the wiring 56. The other end of the wiring 56 may be connected to another connection terminal other than the first connection terminal 53a. The wiring 56 is preferably a bonding wire.

A first semiconductor wafer 62 is laminated on the second semiconductor wafer 55 in the laminate structure 52 with the adhesive layer 61 interposed therebetween. The adhesive layer 61 is formed by photo-curing and thermally curing the adhesive. The adhesive layer 61 is a cured product of the adhesive.

The substrate 53 has a second connection terminal 53b on an upper surface of the substrate. The first semiconductor wafer 62 has a connection terminal 62a on an upper surface of the first semiconductor wafer. A wiring 63 is led-out from the connection terminal 62a. One end of the wiring 63 is connected to the connection terminal 62a provided on the first semiconductor wafer 62. The other end of the wiring 63 is connected to a second connection terminal 53b provided on the substrate 53. The connection terminal 62a is electrically connected to the second connection terminal 53b by the wiring 63. The other end of the wiring 63 may be connected to another connection terminal other than the second connection terminal 53b. The wiring 63 is preferably a bonding wire.

The semiconductor device 51 can be formed by ejecting an adhesive which has photocurability and heat-curability, and is liquid from an inkjet device to the second semiconductor wafer 55 to form an adhesive layer 61. On the other hand, the semiconductor device 71 can be formed by ejecting an adhesive which has photocurability and heat-curability, and is liquid from an inkjet device to the substrate 53A to form an adhesive layer 72.

Hereinafter, the present invention will be specifically explained by way of examples and comparative examples. The present invention is not limited to the following examples.

### Synthesis of Compound Having Thiirane Group (A) :

Into a 2 l reactor equipped with a stirrer, a cooler and a thermometer, 250 ml of ethanol, 250 ml of pure water and 20 g of potassium thiocyanate were charged, and potassium thiocyanate was dissolved to prepare a first solution. Thereafter, a temperature within the reactor was maintained in a range of 20°C to 25°C. Then, 160 g of a bisphenol A epoxy resin was added dropwise at an addition rate of 5 ml/min while stirring the first solution in the reactor maintained at a temperature of 20°C to 25°C. After dropwise addition, the resulting mixture was further stirred for 30 minutes to obtain an epoxy compound-containing mixed solution. Next, a second solution formed by dissolving 20 g of potassium thiocyanate in a solution containing 100 ml of pure water and 100 ml of ethanol was prepared. The resulting second solution was added to the obtained epoxy compound-containing mixed solution at a rate of 5 ml/min, and then the resulting mixture was stirred for 30 minutes. After stirring, the second solution formed by dissolving 20 g of potassium thiocyanate in a solution containing 100 ml of pure water and 100 ml of ethanol was further prepared, and further charged into the reactor at a rate of 5 ml/minute, and the resulting mixture was stirred for 30 minutes. Thereafter, the temperature within a reaction container was lowered to 10°C by cooling, and stirred for 2 hours to react the solution. Next, 100 ml of saturated saline solution was charged into the reaction container and the resulting mixture was stirred for 10 minutes. Then, 300 ml of toluene was further added and the resulting mixture was stirred for 10 minutes. Thereafter, the solution in the container was transferred to a separatory funnel and left standing for 2 hours to separate the solution. A solution at a lower portion in the separatory funnel was drained out, and a supernatant solution was taken out. To the taken out supernatant solution, 100 ml of toluene was added, and the resulting mixture was stirred and left standing for 2 hours. 100 ml of toluene was further added, and the resulting mixture was stirred and left standing for 2 hours. Next, 50 g of magnesium sulfate was added to the supernatant solution containing added toluene and the resulting mixture was stirred for 5 minutes. Then, magnesium sulfate was removed with a filter paper and the solution was separated. Using a vacuum drier, the separated solution was dried at 80°C at a reduced pressure to remove a remaining solvent. Thus, a compound having a thiirane group (A) in which an epoxy group is substituted with a thiirane group which is liquid at 25°C was obtained.

### Synthesis of Compound Having Thiirane Group (B)

A compound having a thiirane group (B) in which a thiirane group substitutes for an epoxy group which is liquid at 25°C was obtained by the same operation as in Synthesis of Compound Having Thiirane Group (A) except for changing the bisphenol A epoxy resin to 4-hydroxybutyl acrylate glycidyl ether in Synthesis of Compound Having Thiirane Group (A).

### (Example 1)

### (Preparation of Adhesive A)

Two parts by weight of tricyclodecanedimethanol diacrylate ("IRR-214K" manufactured by DAICEL-ALLNEX LTD.), 11 parts by weight of lauryl acrylate ("L-A" manufactured by KYOEISHA CHEMICAL CO., LTD.), respectively as a photocurable compound, 41 parts by weight of 4-hydroxybutyl acrylate glycidyl ether ("4HBAGE" manufactured by Nippon Kasei Chemical Co., Ltd.) as a photocurable and thermosetting compound, 20 parts by weight of a bisphenol A epoxy resin ("YD-127" manufactured by NIPPON STEEL & SUMIKIN CHEMICAL CO., LTD.) as a thermosetting compound, 20 parts by weight of an acid anhydride having a terpene skeleton ("YH 306" manufactured by Mitsubishi Chemical Corporation) as a thermal curing agent, 1 part by weight of DBU/octanoic acid salt ("UCAT SA 102" manufactured by San-Apro Ltd.) as a curing accelerator, and 5 parts by weight of 2-benzyl-2-dimethylamino-1-(4-morpholinophenyl)-butanone-1 ("IRGACURE 369" manufactured by BASF CORPORATION) as a photopolymerization initiator were uniformly mixed to obtain an adhesive A.

### (Examples 2 to 16 and Comparative Examples 1 to 3)

### (Preparation of Adhesives B to P)

Adhesives B to S were prepared in the same manner as in the above Preparation of Adhesive A except for mixing components shown in Table 1 described below in mixing ratios shown in Tables 2 and 3 described below.

### (Evaluation)

### (Viscosity at 25°C and at 10 rpm of Adhesive)

The viscosity at 25°C and at 10 rpm of each of the adhesives was measured according to JIS K 2283 using an E-type viscometer ("TVE-22L" manufactured by Toki Sangyo Co., Ltd.). The measured viscosity was rated according to the following criteria.

### [Rating Criteria of Viscosity]

A: Viscosity is higher than 1600 mPa·s
B: Viscosity is higher than 1000 mPa·s and 1600 mPa·s or lower
C: Viscosity is higher than 500 mPa·s and 1000 mPa·s or lower
D: Viscosity is at least 160 mPa·s and at most 500 mPa·s
E: Viscosity is at least 5 mPa·s and lower than 160 mPa·s
F: Viscosity is lower than 5 mPa·s

### (Evaluation of Elastic Modulus)

An adhesive was applied onto a substrate with a spin coater so as to be 20 µm in thickness. The substrate provided with the adhesive applied was irradiated with light at 25°C for 10 seconds using an exposure device (ultra-high pressure mercury lamp, "JL-4300-3" manufactured by ORC MANUFACTURING CO., LTD.) which was adjusted so that the illumination at a wavelength of 365 nm measured with an illuminance meter ("UIT-201" manufactured by USHIO INC.) is 100 mW/cm² (cumulative light quantity 1000 mJ/cm²). The elastic modulus of the resulting B-staged sample was measured at 25°C in the conditions of a measurement plate: parallel plates with a diameter of 8 mm and a frequency of 1 Hz using a viscoelasticity measurement apparatus ARES manufactured by TA Instruments Japan Inc.

### (Checking of Void of Adhesive Layer in Semiconductor Device)

A BGA substrate (thickness 0.3 mm, a commercially available solder resist is applied, 90 locations (5 lines × 16 rows) are provided on which a semiconductor chip with a size of 10 mm × 10 mm is placed) having a height difference of wiring of 5 µm was prepared. An adhesive layer was formed undergoing the steps shown in FIGs. 2(a) to 2(e) according to the above-mentioned method for producing an electronic component of an embodiment of the present invention. An adhesive layer having a thickness of 30 µm was formed by repeating the application step of applying the adhesive while circulating the adhesive at 70°C, and the first light irradiation step (irradiated at 100 mW/cm² for 0.1 second using a UV-LED lamp with a main wavelength of 365 nm), and the adhesive layer was photo-cured in the second light irradiation step (irradiated at 100 mW/cm² for 10 seconds using a ultra-high pressure mercury lamp). Thereafter, a silicon bare chip considered as a semiconductor chip (10 mm long, 10 mm wide and 80 µm thick) was laminated on the adhesive layer at a temperature of 110°C and at a pressure of 0.2 MPa using a die bonding device. After the silicon bare chip was laminated, it was confirmed that protrusion of the adhesive layer was less than 100 µm using a light microscope ("Digital Microscope VH-Z100" manufactured by KEYENCE CORPORATION). The obtained laminates were placed in an oven at 160°C and heated for 3 hours to be thermally cured to obtain 90 semiconductor devices (laminate structure).

Voids of the adhesive layer in the obtained semiconductor device were observed using an ultrasonic inspection imaging device ("mi-scope hyper II" manufactured by Hitachi Construction Machinery Finetec Co., Ltd.), and evaluated according to the following criteria.

### [Evaluation Criteria of Void]

○○: Void was little observed
○: Void was observed slightly (there is no problem for use)
×: Void was observed (there is a problem for use)

### (Checking of Displacement of Semiconductor Chip in Semiconductor Device)

Using a light microscope ("Digital Microscope VH-Z100" manufactured by KEYENCE CORPORATION), displacement of a semiconductor chip in the semiconductor devices obtained in evaluation of Checking of Void was observed and rated according to the following criteria. In addition, it was confirmed that when the semiconductor chip is displaced, the thickness accuracy of an adhesive layer is low.

### [Evaluation Criteria of Displacement of Semiconductor Chip]

○: Displacement of a semiconductor chip was little observed (displaced distance was less than 20 µm)
×: Displacement of a semiconductor chip was observed (displaced distance was 20 µm or more)

### (Moisture Absorption/Reflow and Cooling/Heating Cycle Reliability Test of Semiconductor Device)

Semiconductor devices (90 pieces) obtained in evaluation of Checking of Void were left standing at 85°C and 85 RH % for 168 hours to take up moisture. Thereafter, the semiconductor device was passed through a solder reflow furnace (preheating: 150°C, 100 seconds, reflowing: "maximum temperature 260°C") five times. Using a liquid to liquid thermal shock chamber ("TSB-51" manufactured by ESPEC CORPORATION), the semiconductor device subjected to the moisture absorption/reflow test was subjected to a cooling/heating cycle test following a process in which the semiconductor device was held at -55°C for 5 minutes, and then a temperature of the semiconductor device was raised to 150°C, maintained at 150°C for 5 minutes, and then lowered to -50°C as one cycle. The semiconductor device was taken out after 250 cycles, 500 cycles and 1000 cycles, and peeling of the adhesive layer of the semiconductor device was observed using an ultrasonic inspection imaging device ("mi-scope hyper II" manufactured by Hitachi Construction Machinery Finetec Co., Ltd.), and evaluated according to the following criteria.

### [Evaluation Criteria of Moisture Absorption/Reflow and Cooling/Heating Cycle Reliability Test]

○○: not peeled off
○: peeled off slightly (there is no problem for use)
×: peeled off heavily (there is a problem for use)

Details of compounding components used are shown in Table 1 below, and composition and results are shown in Tables 2 and 3 below. The unit of the compounding components was a part by weight.

**Table 1**

| | | | | |
|---|---|---|---|---|
| Photocurable Compound | Polyfunctional (Meth)acrylate | IRR-214K | Tricyclodecanedimethanol diacrylate | DAICEL-ALLNEX LTD. |
| | | TMPTA | Trimethylolpropane triacrylate | DAICEL-ALLNEX LTD. |
| | | DPHA | Dipentaerythritol hexaacrylate | Shin Nakamura Chemical Co., Ltd. |
| | | EBECRYL 210 | Difunctional aromatic urethane acrylate | DAICEL-ALLNEX LTD. |
| | | UA-4400 | Difunctional polyester-based urethane acrylate | Shin Nakamura Chemical Co., Ltd. |
| | Monofunctional (Meth)acrylate | L-A | Lauryl acrylate | KYOEISHA CHEMICAL CO., LTD. |
| | | S-A | Stearyl acrylate | KYOEISHA CHEMICAL CO., LTD. |
| | | AEH | 2-ethylhexyl acrylate | NIPPON SHOKUBAI CO., LTD. |
| Photocurable and Thermosetting Compound | | 4HBAGE | 4-hydroxybutyl acrylate glycidyl ether | Nippon Kasei Chemical Co., Ltd. |
| | | BLEMMER GH | Glycidyl (meth)acrylate | NOF CORPORATION |
| | | - | Compound having a thiirane group (B) | SEKISUI CHEMICAL CO.,LTD. |
| Thermosetting Compound | | YD-127 | Bisphenol A epoxy resin | NIPPON STEEL & SUMIKIN CHEMICAL CO., LTD. |
| | | YDF170 | Bisphenol F epoxy resin | NIPPON STEEL & SUMIKIN CHEMICAL CO., LTD. |
| | | JER630 | Glycidyl amine type epoxy resin | Mitsubishi Chemical Corporation |
| | | HP7200L | Dicyclopentadiene type epoxy resin | DIC |
| | | EP-4088S | Dicyclopentadiene type epoxy resin | ADEKA |
| | | - | Compound having a thiirane group (A) | SEKISUI CHEMICAL CO.,LTD. |
| Thermal Curing Agent | | YH306 | Acid anhydride having a terpene skeleton | Mitsubishi Chemical Corporation |
| | | MEH8000H | Liquid phenol resin | Meiwa Plastic Industries, Ltd. |
| Photopolymerization Initiator | | IRGACURE369 | 2-benzyl-2-dimethylamino-1-(4-morpholinophenyl)-butanone-1 | BASF |
| Curing Accelerator | | UCAT SA-102 | DBU/OCTANOIC ACID SALT | San-Apro Ltd. |

**Table 2**

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| | | | Adhesive A | Adhesive B | Adhesive C | Adhesive D | Adhesive E | Adhesive F | Adhesive G | Adhesive H | Adhesive I | Adhesive J | Adhesive K |
| Photocurable Compound | Polyfunctional (Meth)acrylate | IRR-214K | 2 | 2 | 2 | | | 2 | 2 | 2 | 2 | 2 | 2 |
| | | TMPTA | | | | 2 | | | | | | | |
| | | DPHA | | | | | 2 | | | | | | |
| | | EBECRYL 210 | | | | | | | | | | | |
| | | UA-4400 | | | | | | | | | | | |
| | Monofunctional (Meth)acrylate | L-A | 11 | | | | | | | | | | |
| | | S-A | | 11 | | | | | | | | | |
| | | AEH | | | 11 | 11 | 11 | 11 | 11 | 11 | 11 | 11 | 11 |
| Photocurable and Thermosetting Compound | | 4HBAGE | 41 | 41 | 41 | 41 | 41 | | 41 | 41 | 41 | 41 | 41 |
| | | BLEMMER GH | | | | | | 41 | | | | | |
| | | Compound having a thiirane group (B) | | | | | | | | | | | |
| Thermosetting Compound | | YD-127 | 20 | 20 | 20 | 20 | 20 | 20 | | | | | 20 |
| | | YDF170 | | | | | | | 20 | | | | |
| | | JER630 | | | | | | | | 20 | | | |
| | | HP7200L | | | | | | | | | 20 | | |
| | | EP-4088S | | | | | | | | | | 20 | |
| | | Compound having a thiirane group (A) | | | | | | | | | | | |
| Thermal Curing Agent | | YH306 | 20 | 20 | 20 | 20 | 20 | 20 | 20 | 20 | 20 | 20 | |
| | | MEH8000H | | | | | | | | | | | 20 |
| Photopolymerization Initiator | | IRGACURE369 | 5 | 5 | 5 | 5 | 5 | 5 | 5 | 5 | 5 | 5 | 5 |
| Curing Accelerator | | UCAT SA-102 | 1 | 1 | 1 | 1 | 1 | 1 | 1 | 1 | 1 | 1 | 1 |
| Viscosity (at 25°C and at 10 rpm) (mPa·s) | | | D | D | D | D | D | D | D | D | B | D | C |
| Elastic Modulus after Photo-Curing (Pa) | | | 1.0 × 10⁴ | 3.0 × 10⁴ | 6.0 × 10² | 7.0 × 10³ | 8.0 × 10³ | 6.0 × 10⁴ | 8.0 × 10² | 8.0 × 10² | 1.0 × 10³ | 8.0 × 10² | 5.0 × 10³ |
| Checking of Void | | | ○○ | ○○ | ○○ | ○○ | ○○ | ○ | ○○ | ○○ | ○○ | ○○ | ○○ |
| Displacement of Semiconductor Chip | | | ○ | ○ | ○ | ○ | ○ | ○ | ○ | ○ | ○ | ○ | ○ |
| Moisture Absorption/Reflow and Cooling/Heating Cycle Reliability Test [250 cycles] | | | ○○ | ○○ | ○○ | ○○ | ○○ | ○○ | ○○ | ○○ | ○○ | ○○ | ○○ |
| Moisture Absorption/Reflow and Cooling/Heating Cycle Reliability Test [500 cycles] | | | ○○ | ○○ | ○○ | ○○ | ○○ | ○ | ○○ | ○○ | ○○ | ○○ | ○○ |
| Moisture Absorption/Reflow and Cooling/Heating Cycle Reliability Test [1000 cycles] | | | ○ | ○ | ○○ | ○○ | ○○ | ○ | ○○ | ○○ | ○○ | ○○ | ○○ |

**Table 3**

| | | | Comparative Example 1 | Comparative Example 2 | Comparative Example 3 | Example 12 | Example 13 | Example 14 | Example 15 | Example 16 |
|---|---|---|---|---|---|---|---|---|---|---|
| | | | Adhesive L | Adhesive M | Adhesive N | Adhesive O | Adhesive P | Adhesive Q | Adhesive R | Adhesive S |
| Photocurable Compound | Polyfunctional (Meth)acrylate | IRR-214K | 43 | 34 | | 2 | 2 | 8 | | |
| | | TMPTA | | | | | | | | |
| | | DPHA | | | | | | | | |
| | | EBECRYL 210 | | | | | | | 7 | |
| | | UA-4400 | | | | | | | | 7 |
| | Monofunctional (Meth)acrylate | L-A | 11 | 1 | | 11 | 11 | 46 | | |
| | | S-A | | | | | | | | |
| | | AEH | | | 13 | | | | 11 | 11 |
| Photocurable and Thermosetting Compound | | 4HBAGE | | 19 | 41 | | 41 | | 36 | 36 |
| | | BLEMMER GH | | | | | | | | |
| | | Compound having a thiirane group (B) | | | | 41 | | | | |
| Thermosetting Compound | | YD-127 | 20 | 20 | 20 | 20 | | 20 | | |
| | | YDF170 | | | | | | | | |
| | | JER630 | | | | | | | | |
| | | HP7200L | | | | | | | 20 | 20 |
| | | EP-4088S | | | | | | | | |
| | | Compound having a thiirane group (A) | | | | | 20 | | | |
| Thermal Curing Agent | | YH306 | 20 | 20 | 20 | 20 | 20 | 20 | 20 | 20 |
| | | MEH8000H | | | | | | | | |
| Photopolymcrization Initiator | | IRCACURE369 | 5 | 5 | 5 | 5 | 5 | 5 | 5 | 5 |
| Curing Accelerator | | UCAT SA-102 | 1 | 1 | 1 | 1 | 1 | 1 | 1 | 1 |
| Viscosity (at 25°C and at 10 rpm) (mPa·s) | | | D | D | D | D | D | E | D | D |
| Elastic Modulus after Photo-Curing (Pa) | | | 3.0 × 10⁵ | 5.0 × 10⁵ | 3.0 × 10² | 3.9 × 10³ | 3.9 × 10³ | 5.8 × 10⁴ | 5.0 × 10³ | 2.0 × 10³ |
| Checking of Void | | | × | × | ○○ | ○○ | ○○ | ○ | ○○ | ○○ |
| Displacement of Semiconductor Chip | | | ○ | ○ | × | ○ | ○ | ○ | ○ | ○ |
| Moisture Absorption/Reflow and Cooling/Heating Cycle Reliability Test [250 cycles] | | | ○ | × | ○ | ○○ | ○○ | ○ | ○○ | ○○ |
| Moisture Absorption/Reflow and Cooling/Heating Cycle Reliability Test [500 cycles] | | | × | × | × | ○○ | ○○ | ○ | ○○ | ○○ |
| Moisture Absorption/Reflow and Cooling/Heating Cycle Reliability Test [1000 cycles] | | | × | × | × | ○ | ○ | ○ | ○○ | ○○ |

In Checking of Void of Adhesive Layer in Semiconductor Device and Evaluation of Moisture Absorption/Reflow and Cooling/Heating Cycle Reliability Test of Semiconductor Device, the case in which the entire adhesive layer is irradiated with light so as to be 1000 mJ/cm² in the cumulative light quantity in B-staging the adhesive layer was similarly evaluated. Consequently, the same results as in Tables 1 and 2 were obtained.

### DESCRIPTION OF REFERENCE SYMBOLS

- 1: Electronic component
- 1A: Primary laminate
- 2: First electronic component main body
- 3: Adhesive layer (after heating)
- 4: First electronic component main body
- 11, 11X: Inkjet device
- 12: Adhesive layer
- 12A: Adhesive layer irradiated with light by a first light irradiation part
- 12B: Adhesive layer irradiated with light by a second light irradiation part
- 13: First light irradiation part
- 14: Second light irradiation part
- 21: Ink tank
- 22: Ejection portion
- 23, 23X: Circulation channel portion
- 23A: Buffer tank
- 23B: Pump
- 31: Electronic component
- 32: Multilayered adhesive layer (after heating)
- 32A, 32B, 32C: Adhesive layer (after heating)
- 51, 71: Semiconductor device
- 52: Laminate structure
- 53, 53A: Substrate
- 53a: First connection terminal
- 53b: Second connection terminal
- 54, 61, 72: Adhesive layer
- 55: Second semiconductor wafer
- 55a, 73a: Connection terminal
- 56, 63, 74: Wiring
- 62, 73: First semiconductor wafer
- 62a: Connection terminal

## Claims

1. A photocurable and thermosetting adhesive for inkjet containing
(a) a photocurable compound having a (meth)acryloyl group,
(b) a thermosetting compound having an epoxy group or a thiirane group,
(c) a photocurable and thermosetting compound having a (meth)acryloyl group and having an epoxy group or a cyclic thioether group,
(d) a photopolymerization initiator, and
(e) a thermal curing agent,
wherein the photocurable compound (a) contains a photocurable and monofunctional compound having a (meth)acryloyl group and a photocurable and polyfunctional compound having two or more (meth)acryloyl groups, the thermosetting compound (b) contains a novolac type epoxy compound, a bisphenol type epoxy compound, alicyclic epoxy compound or glycidyl amine, and the photocurable and thermosetting compound (c) contains 4-hydroxybutyl(meth)acrylate glycidyl ether,
wherein the content of the photocurable and polyfunctional compound is at least 0.1 wt% and at most 30 wt% in 100 wt% of the total of the whole photocurable compound (a) and the photocurable and thermosetting compound (c),
and wherein the elastic modulus at 25°C of a B-staged adhesive is at least 5.0 × 10² Pa and at most 8.0 × 10⁴ Pa when the B-staged adhesive is obtained by irradiating the adhesive with light of a cumulative light quantity of 1000 mJ/cm² so that illumination at a wavelength of 365 nm is 100 mW/cm².

2. The photocurable and thermosetting adhesive for inkjet according to claim 1, wherein the photocurable and monofunctional compound includes 2-ethylhexyl (meth) acrylate.

3. The photocurable and thermosetting adhesive for inkjet according to any one of claims 1 to 2, wherein the viscosity at 25°C and at 10 rpm measured according to JIS K 2283 is at least 5 mPa·s and at most 1600 mPa·s.

4. The photocurable and thermosetting adhesive for inkjet according to any one of claims 1 to 3, wherein the adhesive does not include or includes a solvent, and
when the adhesive includes the solvent, the content of the solvent is 1 wt% or less.

5. The photocurable and thermosetting adhesive for inkjet according to any one of claims 1 to 4, wherein the adhesive does not include or includes fillers, and
when the adhesive includes the fillers, the content of the fillers is 1 wt% or less.

6. A method for producing a semiconductor device comprising:
an application step of applying the photocurable and thermosetting adhesive for inkjet according to any one of claims 1 to 5 onto the surface of a support member for mounting a semiconductor element or a semiconductor element using an inkjet device to form an adhesive layer;
a step of allowing curing of the adhesive layer to proceed by light irradiation to form a B-staged adhesive layer;
a step of laminating a semiconductor element on the surface opposite to a side of the support member or the semiconductor element of the B-staged adhesive layer; and
a step of thermally curing the B-staged adhesive layer after the lamination of the semiconductor element.

7. A method for producing a semiconductor device comprising:
an application step of ejecting the photocurable and thermosetting adhesive for inkjet according to any one of claims 1 to 5 to the surface of a semiconductor wafer using an inkjet device to form an adhesive layer;
a step of allowing curing of the adhesive layer to proceed by light irradiation to form a B-staged adhesive layer;
a step of laminating a cover glass on the surface opposite to a side of the semiconductor wafer of the B-staged adhesive layer to prepare a laminate;
a step of thermally curing the B-staged adhesive layer in the laminate; and
a step of cutting the laminate after thermal curing.

8. The method for producing a semiconductor device according to claim 6 or 7, wherein the elastic modulus at 25°C of the B-staged adhesive layer is set to at least 5.0 × 10² Pa and at most 8.0 × 10⁴ Pa.

9. The method for producing a semiconductor device according to any one of claims 6 to 8,
wherein the inkjet device has an ink tank in which the photocurable and thermosetting adhesive for inkjet is stored; an ejection portion which is connected to the ink tank and from which the photocurable and thermosetting adhesive for inkjet is ejected; and a circulation channel portion connected to the ejection portion at its one end and connected to the ink tank at the other end, the inside of which the photocurable and thermosetting adhesive for inkjet flows through, and
in the application step, the photocurable and thermosetting adhesive for inkjet is applied while circulating it by transferring the photocurable and thermosetting adhesive for inkjet from the ink tank to the ejection portion, and then transferring the photocurable and thermosetting adhesive for inkjet not ejected from the ejection portion to the ink tank through the circulation channel portion in the inkjet device.

10. The method for producing a semiconductor device according to claim 9, wherein a temperature of the photocurable and thermosetting adhesive for inkjet being circulated is 40°C or higher and 100°C or lower.

11. An electronic component comprising a first electronic component main body, a second electronic component main body, and an adhesive layer making connection between the first electronic component main body and the second electronic component main body,
wherein the adhesive layer is a cured product of the photocurable and thermosetting adhesive for inkjet according to any one of claims 1 to 5.

12. The electronic component according to claim 11,
the first electronic component main body is a support member for mounting a semiconductor element or a semiconductor element, and
the second electronic component main body is a semiconductor element.

## Patentansprüche

1. Photohärtbarer und wärmehärtbarer Klebstoff für einen Tintenstrahl enthaltend
(a) eine photohärtbare Verbindung mit einer (Meth)acryloylgruppe,
(b) eine wärmehärtbare Verbindung mit einer Epoxygruppe oder einer Thiirangruppe,
(c) eine photohärtbare und wärmehärtbare Verbindung mit einer (Meth)acryloylgruppe und mit einer Epoxygruppe oder einer cyclischen Thioethergruppe,
(d) einen Photopolymerisationsinitiator und
(e) ein thermisches Härtungsmittel,
wobei die photohärtbare Verbindung (a) eine photohärtbare und monofunktionelle Verbindung mit einer (Meth)acryloylgruppe und eine photohärtbare und polyfunktionelle Verbindung mit zwei oder mehr (Meth)acryloylgruppen enthält, die wärmehärtbare Verbindung (b) eine Epoxidverbindung vom Novolak-Typ, eine Epoxidverbindung vom Bisphenol-Typ, eine alicyclische Epoxidverbindung oder Glycidylamin enthält, und die photohärtbare und wärmehärtbare Verbindung (c) 4-Hydroxybutyl(meth)acrylatglycidylether enthält,
wobei der Gehalt der photohärtbaren und polyfunktionellen Verbindung mindestens 0,1 Gew.-% und höchstens 30 Gew.-% in 100 Gew.-% der gesamten photohärtbaren Verbindung (a) und der photohärtbaren und wärmehärtbaren Verbindung (c) beträgt, und wobei das Elastizitätsmodul bei 25°C eines B-Stufen-Klebstoffs mindestens 5,0 × 10² Pa und höchstens 8,0 × 10⁴ Pa beträgt, wenn der B-Stufen-Klebstoff durch Bestrahlung des Klebstoffs mit Licht einer kumulativen Lichtmenge von 1000 mJ/cm² erhalten wird, so dass die Beleuchtung bei einer Wellenlänge von 365 nm 100 mW/cm² beträgt.

2. Photohärtbarer und wärmehärtbarer Klebstoff für einen Tintenstrahl nach Anspruch 1, wobei die photohärtbare und monofunktionelle Verbindung 2-Ethylhexyl(meth)acrylat enthält.

3. Photohärtbarer und wärmehärtbarer Klebstoff für einen Tintenstrahl nach einem der Ansprüche 1 bis 2, wobei die Viskosität bei 25°C und bei 10 U/min, gemessen nach JIS K 2283, mindestens 5 mPa•s und höchstens 1600 mPa•s beträgt.

4. Photohärtbarer und wärmehärtbarer Klebstoff für einen Tintenstrahl nach einem der Ansprüche 1 bis 3, wobei der Klebstoff kein Lösungsmittel enthält oder ein Lösungsmittel enthält, und
wenn der Klebstoff das Lösungsmittel enthält, der Gehalt des Lösungsmittels 1 Gew.-% oder weniger beträgt.

5. Photohärtbarer und wärmehärtbarer Klebstoff für einen Tintenstrahl nach einem der Ansprüche 1 bis 4, wobei der Klebstoff keine Füllstoffe enthält oder Füllstoffe enthält, und
wenn der Klebstoff die Füllstoffe enthält, der Gehalt der Füllstoffe 1 Gew.-% oder weniger beträgt.

6. Verfahren zur Herstellung einer Halbleitervorrichtung, umfassend:
einen Applikationsschritt des Auftragens des photohärtbaren und wärmehärtbaren Klebstoffs für einen Tintenstrahl nach einem der Ansprüche 1 bis 5 auf die Oberfläche eines Trägerelements zur Montage eines Halbleiterelements oder eines Halbleiterelements unter Verwendung einer Tintenstrahlvorrichtung, um eine Klebstoffschicht zu bilden;
einen Schritt des Aushärtens der Klebstoffschicht durch Lichtbestrahlung, um eine B-stufige Klebstoffschicht zu bilden;
einen Schritt des Laminierens eines Halbleiterelements auf die Oberfläche, die einer Seite des Trägerelements oder des Halbleiterelements der B-stufigen Klebstoffschicht gegenüberliegt, und
einen Schritt des thermischen Aushärtens der B-stufigen Klebstoffschicht nach dem Laminieren des Halbleiterelements.

7. Verfahren zur Herstellung einer Halbleitervorrichtung, umfassend:
einen Applikationsschritt des Ausstoßens des photohärtbaren und wärmehärtbaren Klebstoffs für einen Tintenstrahl nach einem der Ansprüche 1 bis 5 auf die Oberfläche eines Halbleiterwafers unter Verwendung einer Tintenstrahlvorrichtung, um eine Klebstoffschicht zu bilden;
einen Schritt des Aushärtens der Klebstoffschicht durch Lichtbestrahlung, um eine B-stufige Klebstoffschicht zu bilden;
einen Schritt des Laminierens eines Deckglases auf die Oberfläche, die einer Seite des Halbleiterwafers der B-stufigen Klebstoffschicht gegenüberliegt, um ein Laminat herzustellen;
einen Schritt des thermischen Aushärtens der B-stufigen Klebstoffschicht in dem Laminat; und
einen Schritt des Schneidens des Laminats nach dem thermischen Aushärten.

8. Verfahren zur Herstellung einer Halbleitervorrichtung nach Anspruch 6 oder 7, wobei das Elastizitätsmodul bei 25°C der B-stufigen Klebstoffschicht auf mindestens 5,0 × 10² Pa und höchstens 8,0 × 10⁴ Pa eingestellt ist.

9. Verfahren zur Herstellung einer Halbleitervorrichtung nach einem der Ansprüche 6 bis 8,
wobei die Tintenstrahlvorrichtung einen Tintentank, in dem der photohärtbare und wärmehärtbare Klebstoff für einen Tintenstrahl gelagert wird, einen Ausstoßabschnitt, der mit dem Tintentank verbunden ist und aus dem der photohärtbare und wärmehärtbare Klebstoff für einen Tintenstrahl ausgestoßen wird, und einen Zirkulationskanalabschnitt aufweist, der an seinem einen Ende mit dem Ausstoßabschnitt und an dem anderen Ende mit dem Tintentank verbunden ist, durch dessen Inneres der photohärtbare und wärmehärtbare Klebstoff für einen Tintenstrahl durchströmt, und
in dem Applikationsschritt der photohärtbare und wärmehärtbare Klebstoff für einen Tintenstrahl aufgetragen wird, während er zirkuliert, indem der photohärtbare und wärmehärtbare Klebstoff für einen Tintenstrahl von dem Tintentank zu dem Ausstoßabschnitt weitergeleitet wird, und dann der photohärtbare und wärmehärtbare Klebstoff für einen Tintenstrahl, der nicht von dem Ausstoßabschnitt ausgestoßen wird, zu dem Tintentank durch den Zirkulationskanalabschnitt in der Tintenstrahlvorrichtung weitergeleitet wird.

10. Verfahren zur Herstellung einer Halbleitervorrichtung nach Anspruch 9, wobei die Temperatur des photohärtbaren und wärmehärtbaren Klebstoffs für einen Tintenstrahl, der zirkuliert wird, 40°C oder höher und 100°C oder niedriger ist.

11. Elektronisches Bauteil, umfassend einen Hauptkörper eines ersten elektronischen Bauteils, einen Hauptkörper eines zweiten elektronischen Bauteils und eine Klebstoffschicht, die eine Verbindung zwischen dem Hauptkörper des ersten elektronischen Bauteils und dem Hauptkörper des zweiten elektronischen Bauteils herstellt,
wobei die Klebstoffschicht ein gehärtetes Produkt des photohärtbaren und wärmehärtbaren Klebstoffs für einen Tintenstrahl nach einem der Ansprüche 1 bis 5 ist.

12. Elektronisches Bauteil nach Anspruch 11,
wobei der Hauptkörper des ersten elektronischen Bauteils ein Trägerelement zur Montage eines Halbleiterelements oder ein Halbleiterelement ist, und
der Hauptkörper des zweiten elektronischen Bauteils ein Halbleiterelement ist.

## Revendications

1. Adhésif photodurcissable et thermodurcissable pour jet d'encre contenant :
(a) un composé photodurcissable possédant un groupe (méth)acryloyle,
(b) un composé thermodurcissable possédant un groupe époxyde ou un groupe thiirane,
(c) un composé photodurcissable et thermodurcissable possédant un groupe (méth)acryloyle et possédant un groupe époxyde ou un groupe thioéther cyclique,
(d) un initiateur de photopolymérisation, et
(e) un agent de durcissement thermique,
dans lequel le composé photodurcissable (a) contient un composé photodurcissable et monofonctionnel possédant un groupe (méth)acryloyle et un composé photodurcissable et polyfonctionnel possédant deux groupes (méth)acryloyle ou plus, le composé thermodurcissable (b) contient un composé époxyde de type novolaque, un composé époxyde de type bisphénol, un composé époxyde alicyclique ou une amine de glycidyle, et le composé photodurcissable et thermodurcissable (c) contient un éther de 4-hydroxybutyl(méth)acrylate de glycidyle,
dans lequel la teneur en composé photodurcissable et polyfonctionnel est d'au moins 0,1 % en poids et d'au plus 30 % en poids dans 100 % en poids du total du composé photodurcissable (a) entier et du composé photodurcissable et thermodurcissable (c),
et dans lequel le module d'élasticité à 25 °C d'un adhésif de stade B est d'au moins 5,0 × 10² Pa et d'au plus 8,0 × 10⁴ Pa lorsque l'adhésif de stade B est obtenu en projetant de la lumière sur l'adhésif avec une quantité de lumière cumulée de 1 000 mJ/cm² de sorte qu'un éclairement lumineux à une longueur d'onde de 365 nm est de 100 mW/cm².

2. Adhésif photodurcissable et thermodurcissable pour jet d'encre selon la revendication 1, dans lequel le composé photodurcissable et monofonctionnel inclut du (méth)acrylate de 2-éthylhexyle.

3. Adhésif photodurcissable et thermodurcissable pour jet d'encre selon l'une quelconque des revendications 1 à 2, dans lequel la viscosité à 25 °C et à 10 t/min mesurée conformément à la norme JIS K 2283 est d'au moins 5 mPa•s et d'au plus 1 600 mPa•s.

4. Adhésif photodurcissable et thermodurcissable pour jet d'encre selon l'une quelconque des revendications 1 à 3, dans lequel l'adhésif n'inclut pas ou inclut un solvant, et
lorsque l'adhésif inclut le solvant, la teneur en solvant est de 1 % en poids ou moins.

5. Adhésif photodurcissable et thermodurcissable pour jet d'encre selon l'une quelconque des revendications 1 à 4, dans lequel l'adhésif n'inclut pas ou inclut des charges, et
lorsque l'adhésif inclut les charges, la teneur en charges est de 1 % en poids ou moins.

6. Procédé pour produire un dispositif à semi-conducteur comportant :
une étape d'application consistant à appliquer l'adhésif photodurcissable et thermodurcissable pour jet d'encre selon l'une quelconque des revendications 1 à 5 sur la surface d'un élément de support pour monter un élément à semi-conducteur ou un élément à semi-conducteur en utilisant un dispositif à jet d'encre pour former une couche d'adhésif ;
une étape consistant à laisser durcir la couche d'adhésif pour procéder par projection de lumière pour former une couche d'adhésif de stade B ;
une étape consistant à stratifier un élément à semi-conducteur sur la surface opposée à un côté de l'élément de support ou à l'élément à semi-conducteur de la couche d'adhésif de stade B ; et
une étape consistant à durcir thermiquement la couche d'adhésif de stade B après la stratification de l'élément à semi-conducteur.

7. Procédé pour produire un dispositif à semi-conducteur comportant :
une étape d'application consistant à éjecter l'adhésif photodurcissable et thermodurcissable pour jet d'encre selon l'une quelconque des revendications 1 à 5 vers la surface d'une plaquette semi-conductrice en utilisant un dispositif à jet d'encre pour former une couche d'adhésif ;
une étape consistant à laisser durcir la couche d'adhésif pour procéder par projection de lumière pour former une couche d'adhésif de stade B ;
une étape consistant à stratifier un verre de recouvrement sur la surface opposée à un côté de la plaquette semi-conductrice de la couche d'adhésif de stade B pour préparer un stratifié ;
une étape consistant à durcir thermiquement la couche d'adhésif de stade B dans le stratifié ; et
une étape consistant à couper le stratifié après le durcissement thermique.

8. Procédé pour produire un dispositif à semi-conducteur selon la revendication 6 ou 7, dans lequel le module d'élasticité à 25 °C de la couche d'adhésif de stade B est fixé à au moins 5,0 × 10² Pa et à au plus 8,0 × 10⁴ Pa.

9. Procédé pour produire un dispositif à semi-conducteur selon l'une quelconque des revendications 6 à 8,
dans lequel le dispositif à jet d'encre a un réservoir d'encre dans lequel l'adhésif photodurcissable et thermodurcissable pour jet d'encre est stocké ; une partie d'injection qui est reliée au réservoir d'encre et à partir de laquelle l'adhésif photodurcissable et thermodurcissable pour jet d'encre est éjecté ; et une partie de canal de circulation reliée à la partie d'injection à sa première extrémité et reliée au réservoir d'encre à la seconde extrémité, à l'intérieur de laquelle s'écoule l'adhésif photodurcissable et thermodurcissable pour jet d'encre ; et
à l'étape d'application, l'adhésif photodurcissable et thermodurcissable pour jet d'encre est appliqué tout en le faisant circuler par transfert de l'adhésif photodurcissable et thermodurcissable pour jet d'encre depuis le réservoir d'encre jusqu'à la partie d'éjection, et en transférant ensuite l'adhésif photodurcissable et thermodurcissable pour jet d'encre non éjecté de la partie d'injection vers le réservoir d'encre via la partie de canal de circulation dans le dispositif à jet d'encre.

10. Procédé pour produire un dispositif à semi-conducteur selon la revendication 9, dans lequel une température de l'adhésif photodurcissable et thermodurcissable pour jet d'encre en circulation est de 40 °C ou plus et de 100 °C ou moins.

11. Composant électronique comportant un premier corps principal de composant électronique, un second corps principal de composant électronique et une couche d'adhésif réalisant une connexion entre le premier corps principal de composant électronique et le second principal de composant électronique,
dans lequel la couche d'adhésif est un produit durci de l'adhésif photodurcissable et thermodurcissable pour jet d'encre selon l'une quelconque des revendications 1 à 5.

12. Composant électronique selon la revendication 11,
le premier corps principal de composant électronique étant un élément de support pour monter un élément à semi-conducteur ou un élément à semi-conducteur, et
le second corps principal de composant électronique étant un élément à semi-conducteur.
